Europäisches Patentamt

European Patent Office

Office européen des brevets

(11) Numéro de publication : **0 306 359 B1**

# (12) FASCICULE DE BREVET EUROPEEN

(45) Date de publication du fascicule du brevet :
**22.03.95 Bulletin 95/12**

(51) Int. Cl.⁶ : **G01R 31/28,** G01R 31/308

(21) Numéro de dépôt : **88401901.9**

(22) Date de dépôt : **22.07.88**

(54) **Dispositif pour un test d'un circuit.**

(30) Priorité : **31.07.87 FR 8710870**
**20.06.88 FR 8808230**

(43) Date de publication de la demande :
**08.03.89 Bulletin 89/10**

(45) Mention de la délivrance du brevet :
**22.03.95 Bulletin 95/12**

(84) Etats contractants désignés :
**DE FR GB IT NL**

(56) Documents cités :
**EP-A- 0 021 967**
**EP-A- 0 047 162**
**EP-A- 0 299 432**
**WO-A-83/02829**
**US-A- 4 242 635**
**US-A- 4 618 819**
**IEEE Journal of Quantum Electronics vol.**
**QE-19, no. 4, 4 avril 1983, USA pages664 - 667;**
**J.A.Valdmanis et.al.: "Subpicosecond elec-**
**trical sampling"**

(56) Documents cités :
**ELECTRONICS LETTERS. vol. 22, no. 17, août**
**1986, ENAGE GB pages 918 - 919; J.Nees**
**et.al.: "Noncontact electro-optic sampling**
**with a GaAs injection laser"**

(73) Titulaire : **SCHLUMBERGER INDUSTRIES**
**50, avenue Jean Jaurès**
**F-92120 Montrouge (FR)**

(72) Inventeur : **Meyrueix, Paul**
**125, rue Raymond Losserand**
**F-75014 Paris (FR)**
Inventeur : **Tremblay, Gérard**
**Grigny la Roche Rigault**
**F-86200 Loudin (FR)**
Inventeur : **Vernhes, Jean-Paul**
**Schlumberger Technologies**
**1725 Technologies Drive**
**San Jose, CA 95115 (US)**

(74) Mandataire : **Stoole, Brian David et al**
**Schlumberger plc,**
**Patent Department,**
**1 Kingsway, First Floor**
**London WC2B 6XH (GB)**

## Description

PERFECTIONNEMENTS AUX TESTEURS DE CIRCUITS

La présente invention concerne les tests de circuits, et plus particulièrement les tests de circuits assemblés, tels que les cartes de circuits imprimés.

On connait des dispositifs, conçus pour effectuer ces tests de façon automatique, qui réalisent un contact sur des noeuds du circuit, appliquent des signaux d'excitation sur ces noeuds, et observent les signaux produits en réponse par le circuit testé. De tels dispositifs sont souvent dénommés, dans le domaine technique concerné, "équipements de tests automatiques" (connus sous la dénomination anglaise abrégée ATE).

Les ATE peuvent être classés en deux groupes, à savoir celui des testeurs fonctionnels et celui des testeurs in situ. Dans un testeur fonctionnel, les signaux d'excitation sont appliqués, et les signaux de sortie récupérés, exclusivement sur les bornes normales d'entrée et de sortie du circuit, tels par exemple que les connecteurs latéraux d'une carte de circuit imprimé. Ces signaux d'entrée et de sortie sont respectivement appliqués et observés en vue de s'assurer de la fonctionnalité correcte du circuit, considéré comme un ensemble.

Les testeurs fonctionnels présentent le problème que, en particulier lorsque des composants complexes sont impli qués, un grand nombre de combinaisons entrée/sortie (connues sous le nom de "configurations d'états" dans la technique concernée) sont nécessaires pour essayer complètement le circuit, et un test exhaustif peut être très long. Un autre problème est qu'il peut être impossible de tester certains composants du circuit, notamment les mémoires et compteurs numériques, car certains états de ces éléments sont susceptibles de ne pas pouvoir être commandés exclusivement à partir de noeuds externes. Par exemple, il peut n'y avoir aucune connexion externe permettant la remise à zéro d'un compteur. Par ailleurs, certaines conditions de sortie de certains dispositifs sont susceptibles de ne pas pouvoir être distinguées les unes des autres de l'extérieur. Pour ces raisons, certains circuits assemblés ne peuvent être contrôlés que de façon partielle par un testeur fonctionnel.

En revanche, les testeurs in situ ont l'avantage d'être capables de tester individuellement chaque composant d'un circuit assemblé, car ils sont conçus pour permettre l'accès à des noeuds internes du circuit, c'est-à-dire à des noeuds électriques autres que les bornes externes d'entrée et de sortie. Cet avantage est cependant obtenu au prix d'un élément matériel supplémentaire, connu de l'homme de l'art sous le nom de "planche de clous", et qui comprend un ensemble de sondes montées sur ressort, dont chacune a une position qui lui permet d'atteindre un noeud interne du circuit. Grâce à cette planche de clous, les entrées et les sorties peuvent être commandées et mesurées, de manière à vérifier individuellement la fonction de chaque composant.

Les inconvénients des testeurs in situ sont, d'abord, la nécessité de prévoir un dispositif matériel supplémentaire, à savoir la planche de clous, qui doit être adapté à chaque circuit à tester, par exemple à chaque carte à tester, et la nécessité de prévoir des moyens pour tenir en place, et en contact l'un avec l'autre, le circuit à tester et la planche de clous. Un autre inconvénient, tout aussi gênant bien que moins apparent, est le risque d'endommagement des circuits testés lorsqu'une sortie d'un composant est commandée, par l'intermédiaire d'un clou, à un état autre que celui qui devrait logiquement résulter de ses signaux d'entrée, dans le but de tester un autre composant ayant une entrée reliée à cette sortie. Une telle polarisation inverse peut endommager le circuit qui le subit, notamment si ce dernier est le siège d'un échauffement excessif. De surcroît, la miniaturisation des circuits conduit à des difficultés d'accès grandissantes des noeuds internes des circuits testés. Enfin, les testeurs in situ sont intrinsèquement mal adaptés à l'observation des fonctions globales d'un circuit, notamment celles qui font intervenir les calages temporels respectifs des signaux produits par les différents composants (timing).Pour ces raisons, un certain nombre de limitations subsistent encore dans l'emploi de testeurs in situ.

Il est pourtant très souhaitable qu'un ATE puisse fournir à la fois une information analytique permettant de valider le fonctionnement des composants pris individuellement, et une information plus synthétique permettant de valider le fonctionnement global du circuit, lequel dépend non seulement du fonctionnement de chaque composant, mais aussi des interactions entre ces composants.

Alors que les testeurs in situ privilégient le premier aspect au détriment du second, les testeurs fonctionnels font essentiellement l'inverse; aussi la phase dite de diagnostic, au cours de laquelle ces derniers sont mis en oeuvre pour localiser la cause probable d'un défaut, constitue-t-elle une opération délicate. En effet, il est géné ralement impossible de localiser un défaut en excitant des entrées externes et en observant seulement l'état des sorties externes, chaque configuration d'états ne correspondant pas à un unique défaut possible. Ce problème est, dans une certaine mesure, surmonté, dans certains testeurs fonctionnels, en prévoyant une sonde manuelle qui peut être utilisée au cours de la phase de diagnostic sur les cartes qui se sont révélées

2

défectueuses au test fonctionnel.

Au cours de cette phase, un opérateur place la sonde sur divers noeuds du circuit de manière qu'un noeud interne puisse être observé d'une façon assez semblable à celle dont il est observé dans un testeur in situ. Une telle procédure est cependant lente et requiert l'attention d'un opérateur expérimenté.

Dans ce contexte, un objet de la présente invention est de proposer un dispositif qui non seulement permette le test fonctionnel d'un circuit comprenant une pluralité de composants disposés sur un support isolant et reliés les uns aux autres par un réseau de conducteurs s'étendant sur une surface au moins du support, tel qu'une carte de circuit imprimé, mais qui ouvre également la possibilité d'obtenir un diagnostic sur la cause d'un défaut fonctionnel constaté, sans poser les mêmes problèmes mécaniques de connexion ni les problèmes de risques d'endommagement qui se posent dans un testeur in situ.

Selon un premier aspect, le dispositif de la présente invention comprend une couche d'un milieu électro-optique de dimensions sensiblement égales aux dimensions du circuit assemblé, et placé électriquement à proximité de la surface porteuse de conducteurs.

On connaît dans l'art antérieur, par exemple par le brevet US 4,618,819, l'utilisation de matériaux électro-optiques pour l'observation de signaux électriques à distance, c'est-à-dire sans contact mécanique avec le conducteur sur lequel transitent ces signaux. Le système décrit dans ce brevet utilise un cristal électro-optique physiquement placé à proximité de la surface d'un circuit intégré non encore encapsulé. Un faisceau de lumière polarisée est dirigé vers une région du cristal au voisinage d'un conducteur dans lequel circule un signal électrique à mesurer, et réfléchie. Selon des lois bien connues, une caractéristique de la lumière réfléchie est affectée par le champ électrique existant autour du conducteur, de sorte que, par une détection appropriée, ce champ électrique, et le signal qui le produit, peuvent être détectés. Ainsi, une image du signal électrique dans le conducteur peut être obtenue.

Bien que l'invention reprenne certaines caractéristiques de ce dispositif antérieur, elle s'en distingue sur de nombreux points, notamment en raison de ce que le dispositif connu est exclusivement conçu pour la mesure de signaux circulant dans un circuit intégré, et non pour l'examen de signaux circulant entre des composants d'un circuit assemblé, tels que ceux d'une carte de circuit imprimé. Par contre, en d'autres termes, c'est l'objet de l'US 4,618,819 de tester un tel circuit ponctuellement en appliquant et approchant une tête de mesure qui porte un cristal à l'extrémité de cette tête. Il est évident qu'à côté des composants électroniques assemblés et montés sur ledit circuit un placement d'une tête à cristal pourra être problématique et en général demande un positionnement d'une grande exactitude à chaque point à mesurer.

Ainsi, non seulement le dispositif de l'US 4,618,819 ne fait pas apparaître la possibilité technique de mettre en oeuvre un procédé électro-optique sur un circuit entièrement assemblé qui, à la fois présente des dimensions très grandes par rapport à celles d'un circuit intégré et des défauts de planéité très importante que ne présente pas du tout un circuit intégré, mais surtout ce dispositif connu, qui ne conduit qu'à l'obtention d'une information analytique, non représentative d'un fonctionnement global, n'est en rien concerné par les problèmes que posent les tests de circuit assemblés, et ne divulgue ni n'évoque l'aptitude d'un procédé électro-optique à concilier les exigences des tests fonctionnels et des test in situ.

De plus, un autre document connu, l'US 4,242,635, décrit un testeur afin de tester un composant électronique un circuit intégré d'une puce. Cette pastille semi-conductrice destinée à tester est une pièce d'une série d'une production par exemple et pour cela elle doit être préparée d'une manière spéciale. Cette puce est déjà liée aux pattes de contact bondérisés et étant dans son support coquillage qui reste ouvert vers la direction d'où s'approche une tête de mesure. Ledit document 4,242,635 propose une couche de cristaux liquides placée au-dessus de la puce et couvrant cette couche de cristaux liquides se trouve une plaque transparente en verre traitée d'une façon très particulière et sophistiquée qui ne pourrait pas servir afin de tester un circuit complètement assemblé.

En outre, le document EP-A-0297562 est considéré compris dans l'état de la technique selon l'article 54(3)CBE. Ce document décrit également un dispositif permettant de tester des composants électroniques seuls en approchant une tête de mesure similaire à celle du dispositif décrit dans l'US 4,618,819, avec un cristal électro-optique monté sur l'extrémité de la tête. Les problèmes d'un tel testeur ont été déjà expliqués ci-dessus.

Dans une forme de réalisation possible de l'invention, le matériau électro-optique peut être constitué par un film polymère, doté de propriétés électro-optiques. Ce film peut être appliqué directement sur la surface porteuse de conducteurs avant le montage et l'assemblage des composants. Ce film peut être également utilisé pour venir se plaquer contre la surface porteuse de conducteurs après l'assemblage des composants. Il comprend alors des ouvertures dans lesquelles viennent se loger ces composants/ou les points de soudure.

Il peut être incorporé dans une sonde optique pour testeur pour être amené en vue du test à proximité électrique de la surface des conducteurs de la carte à tester. Un tel film peut-être par exemple mis en oeuvre sous la forme d'un transducteur comprenant: un élément d'un tel film électro-optique dimensionné et configuré par rapport aux dimensions et à la configuration du circuit à tester; sur sa face destinée à être placée à proximité électrique des conducteurs, au moins un élément réfléchissant la lumière qui lui parvient après avoir traversé l'épaisseur du film ; et sur son autre face, une couche conductrice transparente ou semi transparente servant d'électrode de référence.

Un dispositif conforme à l'invention et destiné à constituer un ATE comprend, outre la couche de matériau électro-optique.

- des moyens pour diriger de la lumière sur une région quelconque du milieu électro-optique, et pour recevoir de la lumière en retour, de façon telle que les effets électro-optiques apparaissant dans le milieu puissent être détectés,
- des moyens pour appliquer une configuration de signaux de test électriques sur un ou plusieurs noeuds externes de manière qu'un signal de réponse soit produit sur au moins un noeud du circuit, la lumière étant susceptible d'être dirigée sur une région du milieu électro-optique qui est électriquement à proximité d'un conducteur constituant ce noeud, de manière à en produire une image,
- et des moyens pour comparer cette image avec la réponse idéale d'un circuit fonctionnant correctement et pour produire un signal de sortie représentatif de cette comparaison.

Selon un mode de réalisation du dispositif précédent, les moyens pour diriger la lumière comportent des moyens de déflection accousto-optique d'un faisceau de lumière balayant la couche du milieu électro-optique.

Dans une sonde optique réalisée selon les principes précédents, on peut prévoir une lentille de champ dont la dimension est au moins égale du circuit à tester. Avantageusement, cette lentille présente un profil plan convexe, sa face plane étant tournée du côté du circuit à tester. Selon une forme de réalisation, la couche du milieu électro-optique est collée sur la face plane de la lentille.

Dans certaines applications, le milieu électro-optique est choisi avec une structure telle que la composante de champ électrique qui est perpendiculaire au plan de la couche électro-optique soit détectable à l'aide d'une lumière polarisée d'incidence normale au plan de cette couche. Dans le cas d'un film polymère électro-optique, on peut déterminer les propriétés électro-optiques de ce film préalablement, en portant ce film à une température suffisamment élevée au-delà de laquelle ses molécules acquièrement une certaine mobilité et en soumettant le film à champ électrique d'orientation prédéterminée. En refroidissant le film, pendant que le champ reste appliqué, les molécules peuvent se figer en conservant leur orientation préférentielle. Selon les applications, cette orientation peut être choisie par exemple perpendiculaire au plan du film ou dans le plan du film. Il est également possible d'opérer avec une lumière polarisée sous incidence oblique par rapport à la couche, par exemple 45°.

Les moyens d'analyse de l'effet électro-optique créé par les tensions des zones de circuits à tester dans le matériau électro-optique peuvent être analysés par une méthode polarimétrique, comme il vient d'être mentionné, ou, en fonction des conditions opératoires, par une méthode interférométrique.

Lorsque les moyens d'analyse sont du type polarimétrique il est avantageux de prévoir sur le trajet de la lumière provenant de la couche de milieu électro-optique un réflecteur propre à accroître l'ellipticité de cette lumière en affaiblissant la composante du champ électrique de celle-ci dans la direction de polarisation initiale de la lumière incidente. Dans le cas d'une analyse polarimétrique, dans laquelle la lumière issue de la couche électro-optique est analysée suivant deux axes, il peut en outre être intéressant de prévoir un moyen pour imposer à la lumière issue de la couche électro-optique un retard de phase réglable en fonction du signal produit en sortie desdits moyens d'analyse.

Dans le cas d'une analyse selon un principe d'interférométrie de Perot-Fabry, il est également avantageux de prévoir des moyens permettant d'ajuster un paramètre de fonctionnement du système, tel que la longueur de la lumière utilisée, pour positionner les moyens d'analyse dans une zone de sensibilité optimale.

Un ATE selon la présente invention fonctionne de préférence comme un testeur fonctionnel, entrant dans une phase de test dans laquelle seules les entrées et les sorties externes sont excitées et observées, et susceptible d'entrer, en cas d'échec de la phase de test, dans une phase de diagnostic, dans laquelle davantage de noeuds, et notamment des noeuds internes, sont examinés.

Les noeuds sont avantageusement examinés tour à tour, et une multiplicité de configurations de test sont appliquées pendant chaque examen. De préférence, toutes les configurations possibles de test qui affectent le noeud en cours d'examen sont appliquées consécutivement.

Ainsi le dispositif selon l'invention permet de modifier et d'améliorer considérablement les techniques de diagnostic d'une manière qui n'est en rien suggérée par l'art antérieur. En effet, avec les sondes de diagnostic manuelles existantes, il est nécessaire de mettre en oeuvre des séquences de tests complexes aux entrées de circuit pour permettre d'obtenir des signatures de défaut non ambiguës en quelques points de diagnostic seulement (rarement plus d'une dizaine) compte tenu du temps et du degré d'attention nécessité de la part de l'opérateur chargé du diagnostic. La programmation de telles séquences de test contenant de multiples vecteurs pour chaque point de diagnostic est complexe et onéreuse. Au contraire, le dispositif selon l'invention offre la faculté de sonder, en diagnostic, un grand nombre de points très rapidement : de ce fait des séquences de tests simples peuvent être utilisées en chaque point ; la disponibilité de mesures en de nombreux points permet de lever facilement les ambiguités.

Selon une forme de réalisation préférée de l'invention, dans le cas où le milieu électro-optique n'est pas constitué par un film polymère directement déposé sur la surface porteuse de conducteurs, ce milieu est électriquement placé à proximité de cette surface par l'intermédiaire d'un organe d'interface, propre à reporter sur le milieu électro-optique, en conservant leur disposition spatiale relative, les potentiels électriques apparaissant sur ladite surface porteuse de conducteurs. Cet organe d'interface peut comprendre une pluralité de colonnes conductrices essentiellement parallèles les unes aux autres et isolées les unes des autres, l'ensemble adoptant la forme d'un patin flexible de dimensions sensiblement égales à celles du milieu. Ce patin peut en outre présenter une surface profilée de manière à épouser la forme du circuit assemblé, si celui-ci n'est pas plan.

Selon un autre aspect de la présente invention, la lumière peut être dirigée de façon globale sur le milieu électro-optique, ou sur une partie de ce dernier. Le milieu électro-optique comporte une pluralité de sites, individuellement susceptibles de subir une polarisation électrique, sur le trajet de la lumière. A l'utilisation, un seul site peut être mis en fonctionnement par polarisation, de sorte que la lumière détectée à la sortie est représentative d'une seule région du milieu.

L'invention vise également et individuellement, la carte de circuit imprimé, la sonde optique, et le transducteur utilisables pour la mise en oeuvre des principes selon l'invention exposée précédemment.

Pour permettre une meilleure appréciation des caractéristiques et avantages de la présente invention, des modes de réalisation particuliers de cette dernière seront décrits, à titre indicatif et nullement limitatif, en référence aux dessins schématiques annexés, dans lesquels :

- la figure 1 représente un mode de réalisation d'un ATE selon l'invention,
- la figure 2 représente des parties de l'équipement de la figure 1,
- la figure 3 représente un montage optique,
- la figure 4 représente un organe d'interface,
- la figure 5 représente un autre organe d'interface,
- la figure 6 représente une variante d'un ATE conforme à l'invention,
- la figure 7 représente une dépendance de l'effet électro-optique vis-à-vis d'une tension électrique appliquée,
- la figure 8 est une vue en perspective représentant des éléments de l'ATE de la figure 6,
- la figure 9 représente schématiquement un mode de réalisation d'un système de déflexion utilisé pour interroger optiquement la surface de la carte de circuit testée,
- la figure 10 représente une forme de réalisation d'un séparateur optique ;
- la figure 11 illustre la disposition des organes en contact lors d'un test,
- les figures 12a et 12b illustrent l'anisotropie d'indice d'un film électro-optique,
- la figure 13 représente une vue en coupe d'une carte de circuit imprimé à laquelle a été incorporé un film polymètre électro-optique en vue du test,

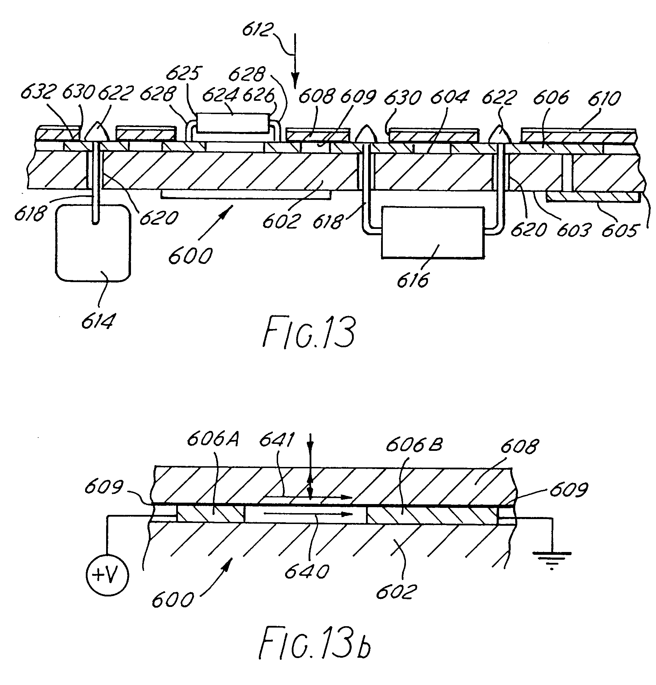

- la figure 13bis représente en détail une variante de la figure 13,

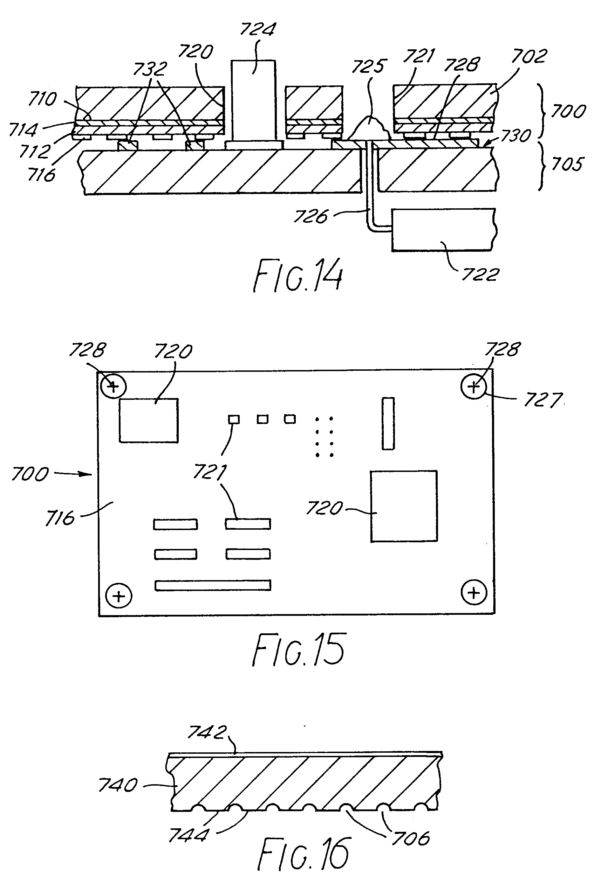

- la figure 14 illustre une réalisation dans laquelle un film électro-optique prédécoupé est positionné sur la carte.
- la figure 15 représente une vue en plan du film utilisé dans la figure 14,

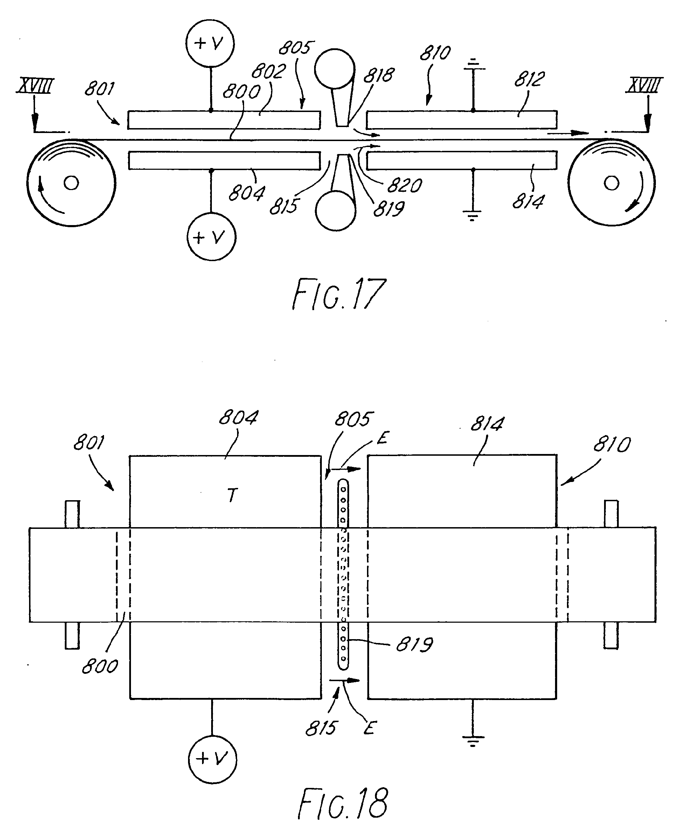

- la figure 16 illustre une variante de réalisation du film utilisé dans la figure 14,
- les figures 17 et 18 illustrent schématiquement un procédé de préparation d'un film polymère utilisable pour la mise en oeuvre de l'invention,

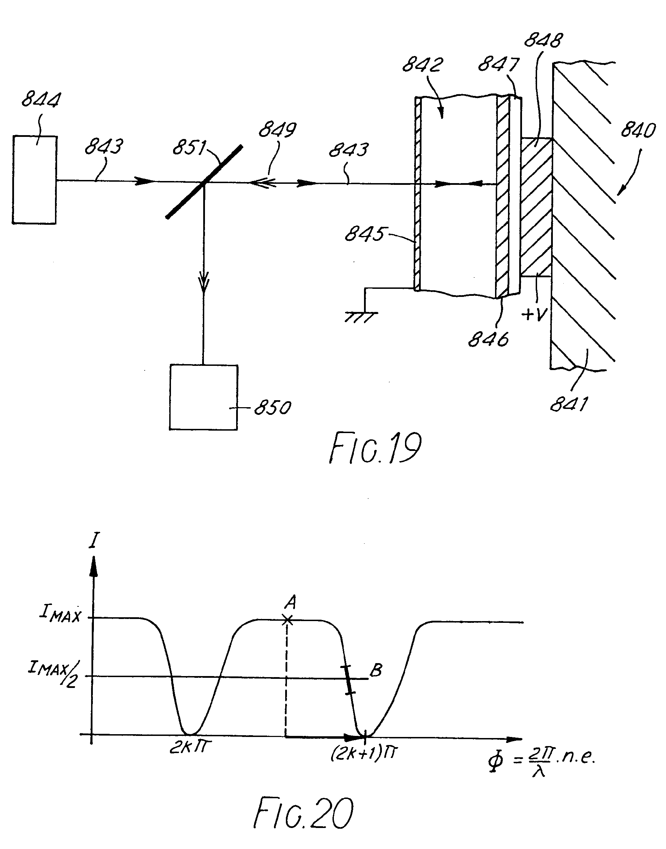

- la figure 19 représente un montage permettant de détecter l'effet Pockels par une technique d'interférométrie-Perot-Fabry.

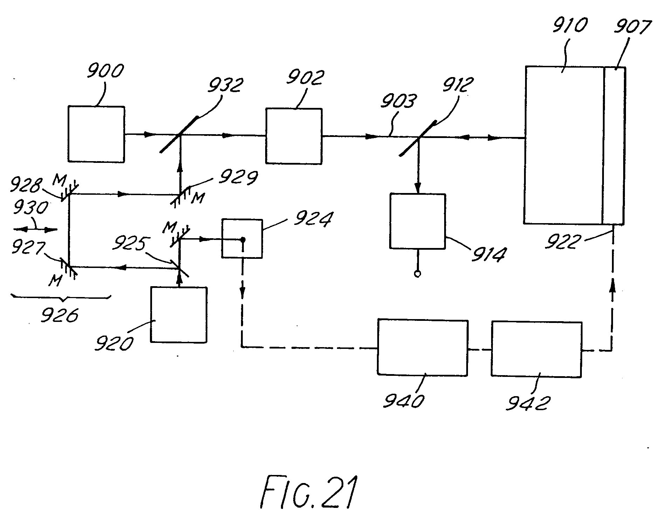

- la figure 20 illustre un réglage de la technique de la figure 19;
- la figure 21 représente un montage permettant une analyse fine des fronts d'onde des signaux aux noeuds du circuit.

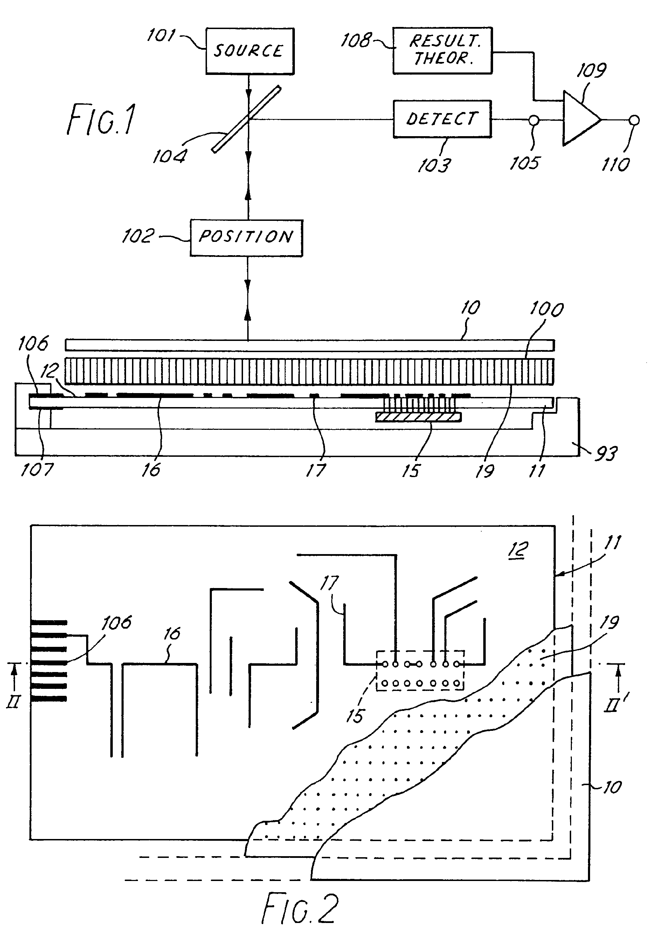

Selon l'invention, un équipement de test automatique comprend (figure 1) une couche d'un milieu électro-optique 10 de dimensions sensiblement égales à celles d'un circuit assemblé, tel qu'une carte de circuit imprimé 11 à tester, l'ensemble étant combiné de façon telle que le milieu électro-optique soit électriquement à proximité de la surface 12 de la carte 11 qui porte le circuit électrique, ce dernier comprenant des composants tels que 15. La surface 12 porte des conducteurs tels que 16 et 17 qui connectent les composants les uns aux autres, et constituent de la sorte des noeuds électriques du circuit. Le milieu 10 peut être électriquement placé à proximité de la surface 12 par le biais d'un organe d'interface 18 qui a pour fonction de transférer vers sa surface supérieure 100 (dans la disposition de la figure 1) les potentiels électriques qui se manifestent sur sa surface inférieure 19.

En fonctionnement, la surface inférieure 19 est en contact avec la carte de circuit imprimé, tandis que la surface supérieure 100 est en contact avec le milieu 10.

La lumière d'une source 101 peut être dirigée vers, et reçue en retour de, toute région de la surface 12 de la carte, au moyen d'un organe de contrôle de position 102 , la lumière reçue étant acheminée vers un détecteur 103 par un séparateur de faisceau lumineux 104, tel qu'une lame semi-transparente.

Le détecteur 103 est sensible aux variations des caractéristiques optiques du milieu 10 qui sont induites par les variations de champ électrique au voisinage de la région d'incidence de la lumière sur le milieu 10, de manière à produire une image de ce champ, adoptant la forme d'un signal électrique sur la sortie 105 de ce détecteur, ce signal étant donc aussi représentatif du signal électrique, quel qu'il soit, qui est présent sur le conducteur dont le potentiel a été transmis vers le milieu électro-optique, dans la région d'incidence de la lumière, par l'organe d'interface 18.

La carte 11 possède des connecteurs latéraux tels que 106 et 107 qui sont imprimés sur cette carte et qui constituent les noeuds externes du circuit, sur lesquels il est possible d'établir une connexion physique grâce à des connecteurs femelles standard de type approprié, dont l'utilisation est bien connue dans les testeurs fonctionnels de l'art antérieur. Un support ou semelle 93 schématiquement représenté permet de manipuler et/ou supporter la carte en cours de test. Une configuration de signaux de test peut être appliquée à ces noeuds externes en vue d'exciter le circuit et de manière à faire apparaître une réponse du circuit au noeud qui est soumis à l'observation électro-optique, ce qui se traduit par l'apparition d'une image de cette réponse sur la sortie 105.

Grâce à une analyse théorique préalable du circuit à tester, le signal de sortie théorique idéal, pour le circuit à tester et la configuration de signaux de test appliquée, peut être déterminé à l'avance comme cela est fait couramment avec les ATE de l'art antérieur, et le signal idéal attendu 108 peut être comparé, par un comparateur 109, au signal de sortie 105 réellement obtenu. Si cette comparaison révèle une différence,le comparateur 109 produit sur sa sortie 110 l'indication d'un défaut révélé par le test.

Il convient de noter que la figure 1 correspond à une vue en coupe d'une carte de circuit imprimé. Pour une meilleure compréhension de la description, une vue en plan de la même carte, avec ses conducteurs (encore appelés "pistes") et un composant électronique est représentée sur la figure 2, la figure 1 correspondant à une vue en coupe suivant la direction II et II' de cette figure 2. Typiquement, une carte de circuit imprimé peut adopter une forme rectangulaire de 200 mm par 300 mm ou davantage, le milieu électro-optique 10 et l'organe d'interface 18 ayant sensiblement les mêmes dimensions. Les composants électroniques, tels que 15, qui sont implantés sur la carte sont le plus souvent des composants numériques en boîtier à deux rangées de broches ; une partie du réseau de pistes interconnectant ces composants est représentée sur la figure 2 ; dans la mesure où les composants sont insérés sur la face inférieure de la carte 11 (dans la disposition de la figure 1), le composant 15, non directement visible, est représenté en pointillés sur la figure 2, à l'exception de ses broches qui, traversant la carte pour être soudées sur les pistes portées par la surface 12, sont visibles sur la figure 2.

Les points de soudure entre les extrémités des broches des composants et les pistes constituent des inégalités importantes à la surface de la carte qui porte ces conducteurs. Sur les cartes terminées, cette surface est entièrement revêtue d'un vernis protecteur qui forme une couche intermédiaire de quelques micromètres qui s'interpose entre les conducteurs de la carte et un organe de test externe. En outre, ces conducteurs sont souvent dans la pratique recouverts d'oxyde qui s'y est formé en cours de fabrication et de stockage. Cet oxyde constitue lui aussi un milieu dont l'existence doit être prise en considération pour la réalisation des testeurs industriels.

Enfin, il est fréquent que les cartes de circuits imprimés modernes comportent également des composants sur la face portant le réseau de pistes conductrices. Il est même courant de trouver des cartes portant des pistes et des composants sur les deux faces.

En fonctionnement, l'organe d'interface 18 est placé en contact avec la surface 12 portant les conducteurs, comme représenté partiellement sur la figure 2. Cet organe d'interface 18 comprend une pluralité de colonnes conductrices, telles que la colonnes 111, arrangées en matrice de façon telle que le potentiel de chaque conducteur peut être reporté sur le milieu électro-optique 10 (également représenté en partie), grâce à au moins une de ces colonnes conductrices. La nature et le fonctionnement de l'organe d'interface 18 seront détaillés dans la suite de la description.

Il est à noter que chacune des colonnes correspond à une région séparément observable du circuit et que la lumière est susceptible d'être dirigée sur chacune d'elles, et reçue en retour de chacune d'elles. La lumière est constituée par un faisceau de lumière polarisée provenant d'un laser, et l'analyse de la lumière reçue en retour consiste en une détection de la rotation du plan de polarisation, par exemple mise en oeuvre par un montage polarimétrique comprenant un prisme de Wollaston séparant la lumière reçue en deux faisceaux pour sa détection. Le détecteur est en fait constitué de deux détecteurs, de manière à permettre une mesure de la

6

différence des intensités des deux faisceaux lumineux, et une compensation des variations d'intensité lumineuse de la source.

Le milieu électro-optique peut être constitué par un cristal. En variante, le matériau électro-optique peut être constitué par un film d'un polymère doté de propriétés électro- optiques. Ce film peut être utilisé à la place d'une plaque de cristal électro-optique dans l'ATE de la figure 1. Il peut être également préalablement prédécoupé pour venir s'ajuster entre les composants de la carte à tester en contact direct avec les piste conductrices de celle-ci sans nécessiter d'organe d'interface ou seulement un tel organe de faible épaisseur. En variante, ce film peut être déposé directement sur la surface porteuse de conducteurs avant mise en place des composants, et dont la face en contact avec les conducteurs possède, naturellement ou grâce à un dépôt sérigraphique de micro-pastilles métalliques, un certain pouvoir de réflexion de la lumière; par exemple, ce film peut être intégré à la carte de circuit imprimé au moment de sa fabrication. Une telle structure, qui permet de se dispenser de l'organe d'interface, conduit à l'obtention de cartes électroniques aptes, dès leur fabrication, à subir un test bénéficiant de tous les avantages l'invention.

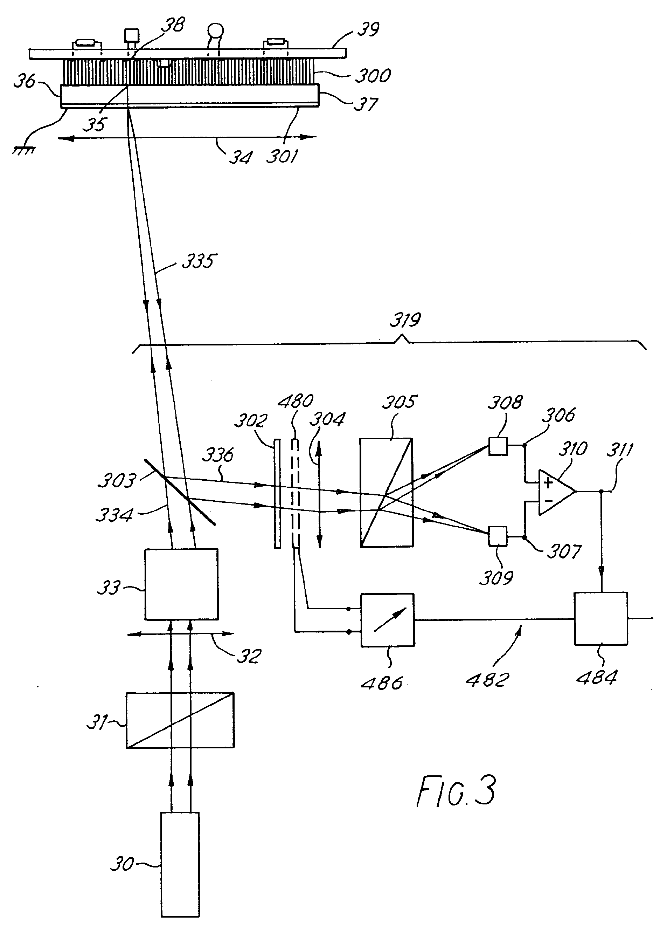

Le mécanisme par lequel les signaux peuvent être détectés par effet électro-optique sera maintenant décrit de façon plus détaillée (figure 3), plus particulièrement en référence au mode de réalisation qui fait intervenir l'organe d'interface, les phénomènes décrits étant cependant les mêmes dans le cas de l'utilisation d'un film polymère.

La lumière d'émission d'un laser 30 (par exemple un laser HeNe de 633 nm de longueur d'onde) est polarisée linéairement par un polariseur 31 et acheminée, via une lentille 32, vers un déflecteur acousto-optique 33 de manière à être dirigée, via une lentille 34, vers un point d'inspection 35 d'une surface réfléchissante 36 d'un cristal électro-optique 37. D'une façon générale on utilise un laser continu de puissance moyenne, soit typiquement 5 à 100 mW.

Le déflecteur acousto-optique 33, connu en soi, est commandé par un signal de tension continue émis par un organe de commande de l'ATE (non représenté), de manière à défléchir la lumière qu'il reçoit sur tout point du milieu électro-optique dont l'examen est désiré.

Dans un mode de réalisation préféré, deux déflecteurs acousto-optiques peuvent être placés en série. Un premier signal de tension contrôle alors la déflexion du faisceau selon une première direction, correspondant par exemple à l'une des deux dimensions de la carte à tester, et l'autre signal de tension commande la déflexion suivant une seconde direction, de préférence perpendiculaire à la première et correspondant par exemple à l'autre dimension de la carte.

Une telle utilisation de deux déflecteurs permet de réduire le temps requis pour passer d'un point d'observation 35 à un autre à des temps de l'ordre de quelques microsecondes au maximum.

La surface réfléchissante 36 est essentiellement isolante, au moins en ce sens qu'un potentiel électrique appliqué en un point de cette surface n'est pas propagé à d'autres points de celle-ci. Ainsi, si les qualités de réflexion de cette surface sont obtenues par un dépôt métallique, nécessairement conducteur, ce dernier ne consiste pas en une couche uniforme, mais en une matrice de pastilles réfléchissantes disposées en damier et non reliées les unes aux autres, dont chacune cependant est électriquement reliée au voisinage d'un point à tester, tel qu'un point de test 38 de la carte 39, grâce à l'organe d'interface 300 (directement dans le cas d'un film polymère). Selon une variante possible, la surface réfléchissante 36 peut être constituée d'un matériau intrinsèquement isolant par exemple une couche fine d'un matériau diélectrique tel qu'une alternance appropriée de couches d'oxyde de titane TiO2 et de silice $SiO_2$.

Une électrode transparente 301, par exemple constituée par un dépôt d'or ou d'aluminium, est disposée en couche sur la première face, rencontrée par la lumière incidente, du cristal électro-optique 37, et cette électrode est maintenue au potentiel de la masse qui constitue la référence des potentiels ; ainsi, si le potentiel électrique du point de test examiné diffère de cette référence, la polarisation de la lumière réfléchie est, en raison du champ électrique appliqué suivant l'épaisseur du cristal électro-optique 37, différente de celle de la lumière incidente, et cette différence est détectée.

Pour un cristal de structure cubique, tel que le germanate de bismuth $Bi_4Ge_3O_{12}$, dont l'axe cristallographique (100) est optiquement orienté de façon normale à une lame quart d'onde 302, le retard de phase de la lumière dû à l'effet electro-optique subi est proportionnel à la différence de potentiel entre les faces du cristal 37 au point d'observation et indépendant de la distribution du champ électrique dans le cristal.

La lumière réfléchie est renvoyée vers la lame quart d'onde 302 par un séparateur 303 ; en aval de la lame 302, la lumière est acheminée, par une lentille 304, vers un analyseur de Wollaston 305, duquel émergent deux faisceaux atteignant des détecteurs photo-électriques respectifs 308 et 309, qui, sur leurs sorties 306 et 307, produisent des signaux électriques respectifs I1 et I2.

Ce type de détection polarimétrique conduit aux relations suivantes :

$$I1 = I. (1 + m)$$

7

et

$$I2 = I.(1 - m),$$

dans lesquelles I est une grandeur proportionnelle à l'intensité lumineuse du laser 30 et dans lesquelles m est le retard de phase détecté, exprimé en radians et supposé petit.

Un amplificateur différentiel 310 recevant les signaux des sorties 306 et 307 produit sur sa sortie 311 un signal I1 - I2, donc égal à 2.I.m. Dans la mesure où, au cours d'un test, les éventuelles variations d'intensité lumineuse du laser 30 correspondent à des fréquences beaucoup plus basses que les fréquences de variation de m, la grandeur m peut être directement obtenue par un filtrage adéquat du signal électrique disponible sur la sortie 311 de l'amplificateur 310. En variante, un signal I1 + I2 peut être utilisé pour asservir l'intensité lumineuse de la source.

Pour un cristal de structure non cubique, tel que le niobate de lithium $LiNbO_3$, l'effet électro-optique est également proportionnel à la différence de potentiel entre les faces du cristal électro-optique. L'emploi d'un tel cristal requiert cependant quelque précaution, dans la mesure où le coefficient de proportionnalité entre la différence de potentiel et l'effet obtenu dépend de l'orientation de coupe du cristal.

Les propriétés souhaitables du cristal électro-optique sont une faible absorption, une faible diffusion, et une faible biréfringence circulaire et linéaire. Si un matériau très biréfringent est utilisé, tel que le niobate de lithium par exemple, une faible variation de l'angle d'incidence de la lumière conduit à une variation sensible du retard de phase statique. Les fluctuations thermiques produisant des variations d'épaisseur du cristal ont des effets similaires, et l'un et l'autre doivent être évités.

Pour améliorer les performances d'un tel matériau biréfringent, une commande de l'état de polarisation de la lumière incidente peut, conformément à la présente invention, être prévu, par exemple en réponse à l'angle d'incidence ou à la température. En outre, ou en variante, le dispositif de l'invention peut comprendre, en tant que milieu électro-optique, une structure de cristaux présentant des orientations perpendiculaires, mais des épaisseurs sensiblement identiques, de manière à atténuer ou supprimer la biréfringence.

Le milieu électro-optique présente avantageusement une résistivité au moins de l'ordre de $10^{10}$ Ohm.cm, en particulier pour tester des circuits basse fréquence, et une constante diélectrique au plus de l'ordre de 100, de manière à n'introduire qu'une faible capacité (1 pF ou moins).

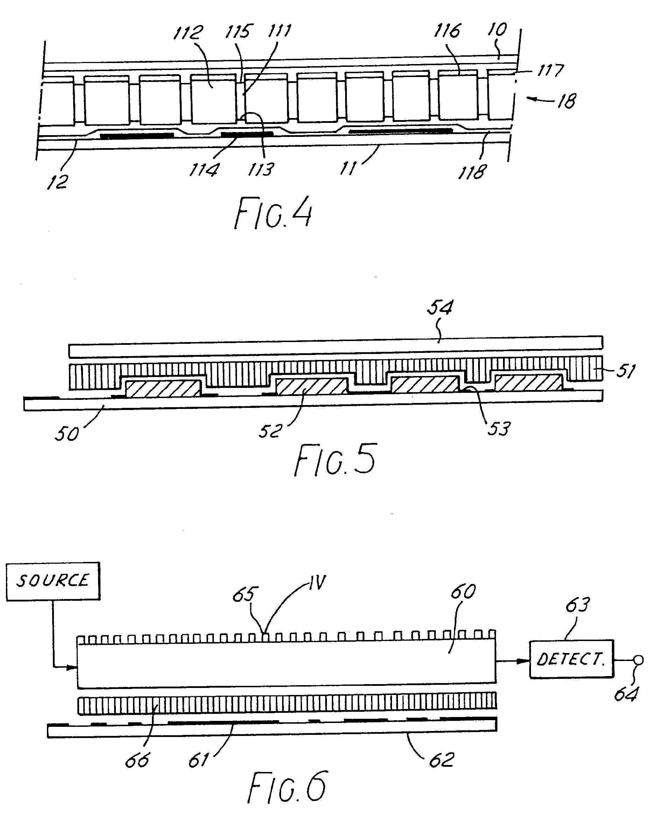

A l'intérieur de l'organe d'interface 18 (figure 4), une colonne conductrice 111 est noyée dans un substrat isolant flexible 112. Chaque colonne, telle que 111, est par exemple cylindrique. Le substrat 112 renferme un ensemble d'autres colonnes parallèles les unes aux autres et espacées les unes des autres suivant la longueur et suivant la largeur de l'organe d'interface 18.

En fonctionnement, cet organe est placé en contact avec la surface porteuse de conducteurs 12 d'une carte 11 de circuit imprimé de manière que la surface inférieure 113 de la colonne 111 soit à proximité d'un conducteur 114 de la surface 12 ; de façon analogue, les surfaces des autres colonnes sont à proximité d'autres conducteurs. Le potentiel électrique dans le conducteur 114 impose un potentiel équivalent dans le conducteur qui constitue la colonne 111, et ce dernier potentiel peut être observé à la surface supérieure 115 de cette colonne.

Un film conducteur 116 est appliqué à la surface supérieure 117 de l'organe 18, sauf au voisinage immédiat des zones dans lesquelles les colonnes conductrices affleurent par leur surface supérieure ; le film conducteur 116 peut être relié à la masse, de manière à produire un saut de potentiel abrupt au voisinage des surfaces supérieures des colonnes, permettant l'observation de l'effet électro-optique comme décrit ci-dessus.

Il est à noter que dans la mesure où aucun passage de courant électrique dans la colonne 111 n'est nécessaire, une résistance élevée peut être tolérée au voisinage du conducteur 114. Ainsi, le dispositif peut être utilisé pour examiner un circuit monté sur la carte, par exemple sur la carte 11, sur laquelle une couche 118 d'un vernis protecteur isolant a été appliquée. Cette propriété constitue un avantage fondamental des équipements automatiques de test conformes à l'invention. Elle permet en effet de tester les cartes à la fin de la série des étapes de production, y compris après l'application du vernis. Avec les testeurs in situ classiques, le vernis ne peut être appliqué avant le test, puisque les clous doivent faire directement contact avec les conducteurs ; même en phase de test fonctionnel, le vernis doit être ôté pour que la sonde manuelle puisse être utilisée. Grâce à la présente invention, les cartes peuvent être testées à l'état fini.

Lorsque la surface porteuse de conducteurs du circuit assemblé à tester présente des reliefs, comme c'est le cas pour la carte 50 représentée sur la figure 5, la surface correspondante de l'organe d'interface 51 est creusée, moulée ou ajourée avec un profil adéquat. La carte 50 porte par exemple un circuit utilisant des composants montés en surface, tels que 52, dont les broches de connexion sont directement rendues solidaires des pistes conductrices 53, sans traverser la carte 50. Dans une telle structure, une surface conductrice plane peut ne pas exister, et c'est la raison pour laquelle l'organe d'interface 51 est adapté à recevoir les composants montés en surface, tout en continuant à présenter une surface plane au voisinage du milieu électro-optique 54.

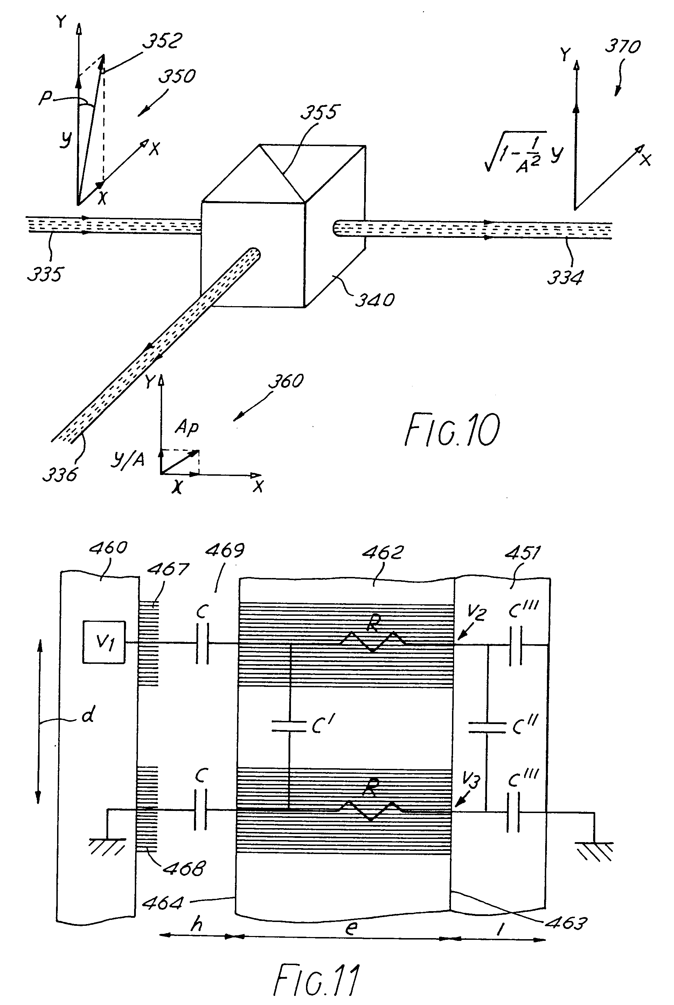

Dans un mode de réalisation d'un testeur selon l'invention, représenté à la figure 9, on utilise en plus d'une déflexion acousto-optique une déflexion mécanique pour élargir la surface de circuit balayée. Comme dans l'exemple de la figure 10, un laser 430 transmet le faisceau de test à un dispositif de déflexion acousto-optique 433 à travers un polariseur 431 et une lentille 432. Le dispositif 433 comprend deux déflecteurs acousto-optiques par exemple des modèles fabriqués par AUTOMATES ET AUTOMATISMES, 19, rue de Paris 78460 CHEVREUSE.

Le premier déflecteur est monté à l'intérieur du boîtier 433 pour défléchir le faisceau laser dans une première direction a et le deuxième déflecteur défléchit le faisceau ainsi dévié dans une direction perpendiculaire b. De la sorte, la combinaison des deux déflecteurs permet de balayer une surface rectangulaire carrée de 50 x 50 millimètres à une distance de 1000 millimètres à la sortie de la lentille 432 (correspondant à sa distance focale).

Le faisceau émergeant du dispositif 433 tombe sur un miroir pivotant 441 d'un premier déflecteur mécanique 443 qui le réfléchit sur un miroir pivotant 442 d'un deuxième déflecteur mécanique 444. La combinaison des débattements des déflecteurs 443 et 444 dans deux directions A et B parallèles à a et b permet au faisceau émergent 445 de balayer une surface rectangulaire de 500 x 500 millimètres dans le plan focal de la lentille.

Le faisceau 445 vient tomber sur la face convexe 449 d'une lentille plan-convexe 450 dont les dimensions sont : 500 x 500 millimètres, réalisée par exemple en verre BK7.

Sur la face plane de la lentille est collée une couche ou plaque rectangulaire 451 d'une mosaïque de cristaux électro-optiques de BGO (germanate de bismuth $Bi_4 Ge_3 O_{12}$). Les dimensions de la lentille 450 et de la plaque de cristal électro-optique 451 correspondent sensiblement à la surface totale susceptible d'être balayée par le faisceau 445 au sortir du système de déflecteurs 443, 444.

La plaque de BGO 451 a une épaisseur d'environ un (1) millimètre. Dans cet exemple, le collage de la plaque BGO 451 à la face plane de la lentille 450 permet d'amortir les vibrations mécaniques qui pourraient naître dans le cristal par suite de phénomènes de résonance piézoélectrique. De telles vibrations doivent être évitées en raison des signaux parasites optiques qu'elles risquent d'engendrer par effet photoélastique dans le cristal.

L'ensemble laser 430, polariseur 431, déflecteurs acousto-optiques et mécaniques 433, 443, 444 ainsi que la lentille 450 avec la plaque BGO 451, est intégré avec le système optique de récupération et de détection de la lumière réfléchie par la plaque 451. Cet ensemble, non représenté sur la figure 9, figure en 319 sur la figure 3 et comprend le séparateur 303, la lame quart d'onde 302 sur lentille 304, le prisme de WOLLASTON 305, les deux détecteurs photoélectriques 308 et 309 et l'amplificateur différentiel 310 pour former une sonde optique incorporée dans la tête d'un ATE.

En fonctionnement, une carte de circuit imprimée 460 (Figure 9) est préalablement revêtue sur sa face à tester d'un organe d'interface 462 (analogue à l'organe 18 de la fig 1) présentant des propriétés de conductivité anisotropiques pour reporter une image des tensions des conducteurs de la carte 460 en contact avec une de ses faces sur son autre face 463. Cette face 463 et la face libre du cristal électro-optique 451 à la base de la sonde optique sont en contact pour le test et fermement appliquées l'une contre l'autre par des moyens de pression non représentés permettant d'éliminer ou de minimiser tout intervalle parasite entre les faces en contact de la plaque BGO 451, de l'organe d'interface 462 et de la carte à tester. Dans cet exemple, on a utilisé comme organe d'interface une feuille d'élastomère fabriquée par JSC TECHNIC en République Fédérale Allemande et disponible sous le nom de ZEBRA bidimensionnel ; son épaisseur peut être comprise entre 0,1 et 5 millimètres par exemple suivant le type de carte et les inégalités à la surface de celle-ci.

Sur la figure 9, la zone quadrillée 470 correspond à une surface élémentaire de balayage acoustooptique de la plaque de cristal de 50 x 50 mm. A l'aide d'un déplacement par pas du système de déflexion mécanique il est possible de réaliser le balayage acousto-optique de cent (100) surfaces élémentaires juxtaposées à la surface du cristal électro-optique 451.

Typiquement, la cadence de balayage acousto-optique qui peut être obtenue est de 100 kHz (fréquence de passage d'un point d'investigation à un autre). Ce balayage mécanique permet de passer d'une zone élémentaire 470 à une autre en 50 millisecondes.

Avec ce dispositif, si l'on arrête le faisceau laser pendant 3 millisecondes en chaque point pour analyser $10^5$ bits de test, on peut tester en 33 secondes 10000 points d'une carte de circuit imprimé de 500 x 500 millimètres capable de fonctionner à 30 mégabits par seconde.

Si on considère (Fig 9) un faisceau 445 de lumière polarisée de façon rectiligne à l'entrée de la plaque de cristal 451, son état de polarisation reste inchangé par la traversée de cette plaque si le conducteur de la carte à tester 460 au voisinage du point d'incidence du faisceau n'est pas sous tension. L'application d'une tension crée un déphasage p(V) entre les deux composantes du champ électrique de la lumière. L'état de polarisation du faisceau qui retraverse la lentille 450 au sortir de la plaque BGO 451 est alors elliptique.

Ce faisceau émergent est renvoyé par le séparateur 303 (Fig. 3) vers la lentille de détection 304 puis est divisé en deux composantes par le prisme de WOLLASTON 305 et les intensités détectées de ces composantes sont représentées par

$$I_1 = 1/2\ Io\ (1\ +\ \cos\ (p + po)$$

$$I_2 = 1/2\ Io\ (1\ -\ \cos\ (p + po))$$

dans lesquelles Io est l'intensité incidente et po est le retard de phase statique introduit par la lame quart d'onde 302.

L'amplificateur différentiel 310 produit un signal S

$$S = I_1 - I_2 = Io\ (p + po)$$

Si le déphasage p est nul, le signal S est négligeable dans de nombreux cas en raison de la petitesse de la variation de polarisation produite dans la plaque 451.

A titre d'exemple, pour un cristal de BGO d'indice 2 et de coefficient électrooptique égal à 1 pm/V, on obtient pour une longueur d'onde laser de 647 nm (laser Krypton) une valeur de

$$p = 8.10^{-4}\ rad/V.$$

En revanche avec une lame quart d'onde, po = pi/2 et

$$S = I_o x\ p$$

le signal S varie linéairement avec V et des valeurs de p de l'ordre de $10^{-4}$ radian peuvent être facilement détectées. Grâce à la méthode différentielle adoptée, cela est vrai même si l'intensité de la source laser subit des fluctuations relativement lentes dans le temps pouvant aller jusqu'à 10 % dans son domaine de fréquence.

Les déformations engendrées par le collage des cristaux de BGO peuvent provoquer des biréfringences parasites qui diffèrent d'un point à l'autre. Il en résulte que po varie d'un point à un autre. On prévoit de ramener po à pi/2 après chaque pointage du faisceau et avant les mesures électriques en insérant une cellule de Kerr 480 entre la lame quart d'onde 302 et le prisme de WOLLASTON. Ce dispositif est constitué par une lame d'un matériau électro-optique placé entre deux électrodes transparentes dans un champ électrique variable alimenté par une liaison de contre-réaction 482 comprenant un commutateur 484 et un amplificateur variable 486 à partir de la sortie 311 de l'amplificateur différentiel 310. Le déphasage introduit par la lame 480 entre les composantes de champ électrique du faisceau qui la traverse s'ajuste ainsi au niveau requis pour annuler la composante continue du signal S correspondant au point testé. Avec des signaux de test à fréquence suffisamment élevée, la partie haute fréquence du signal S contient l'information de test recherchée.

On peut en outre améliorer la profondeur de modulation du dispositif en insérant un polariseur imparfait 340 entre la sortie de la plaque de cristal et la lame quart d'onde 302.

Sur la figure 10 ce polariseur est un cube 340 interposé sur le faisceau 335 sortant de la lentille 34 de la figure 10 et utilisé à la place du séparateur 303.

On a représenté en 350 le système d'axes illustrant la polarisation de la lumière émergeant de la lentille, p étant l'angle de polarisation par rapport à la direction de polarisation linéaire initiale représentée suivant l'axe Y. Les composantes selon les axes X et Y du vecteur 352 , représentant l'onde polarisée du faisceau 335, représentent les grands axes de l'ellipse de polarisation, le prisme de WOLLASTON 305 (fig 3) étant orienté de manière à séparer les composantes de la lumière suivant ces deux axes.

Le cube séparateur 340 sépare le faisceau 335 en deux faisceaux, l'un traversant 334, l'autre réfléchi 336. L'interface 355 du cube est traitée de manière à se comporter comme un mauvais polariseur vis-à-vis de la lumière réfléchie en augmentant l'ellipticité de la polarisation de celle-ci. La composante suivant l'axe Y se trouve fortement réduite contrairement à la composante X comme le montre le diagramme 360 sur la figure 10 et suivant les principes discutés dans la demande de brevet français au nom du demandeur déposée le 30 Mars 1988 sous le numéro 88/04177. Au contraire la portion du faisceau traversant 334 est polarisée linéairement suivant Y (diagramme 370).

Les composantes $I_1$ et $I_2$ recueillies après séparation du faisceau 336 par le prisme de WOLLASTON s'expriment alors comme suit :

$$I_1 = (I\ +\ Ap)\ Io/2A^2$$

$$I_2 = (I\ -\ Ap)\ Io/2A^2$$

A est un coefficient supérieur à 1 fixé par les caractéristiques du cube polariseur 340. Ces relations montrent qu'on peut donc utiliser un laser plus puissant pour accroître la profondeur de modulation sans saturer les détecteurs en sortie du prisme de WOLLASTON.

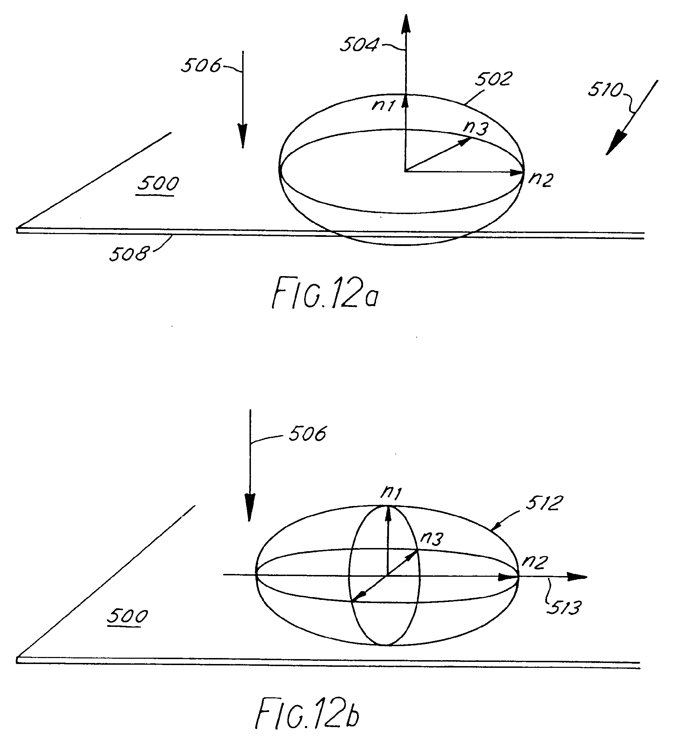

On a représenté schématiquement sur la figure 11 les interfaces entre la carte de circuits imprimés 460, l'organe d'interface 462 et la plaque de cristal 451. Deux conducteurs 467 et 468 formant deux points de test sont schématisés l'un sous tension $V_1$, l'autre à la masse. Les conducteurs sont souvent recouverts d'oxyde. Lorsque la carte est terminée, ils sont recouverts d'un vernis. Ces couches d'oxyde ou de vernis forment un intervalle 469 entre la surface supérieure de la carte et la face en regard 464 de l'organe d'interface 462.

Un schéma de circuit électrique équivalent au dispositif apparaît sur la figure 11. En raison des capacités du cristal, du connecteur et de l'intervalle 469, la tension V2 qui se développe dans le cristal en réponse à V1 est d'autant plus faible que la capacité de l'intervalle 469 est faible et que celle du cristal est grande. En outre, pour un organe d'interface 462 donné dont l'épaisseur est imposée par les composants montés à la surface de la carte 460, plus l'intervalle 469 est grand et plus la diaphonie (crosstalk) représentée par le rapport V3/V2 est forte.

Dans un exemple, les paramètres étaient les suivants :
. épaisseur de l'organe d'interface 462          e = 2 mm
. épaisseur du cristal BGO 451          l = 1 mm
. constante diélectrique de cristal          e' = 16
. distance des deux points tests          d = 400 microns

La diaphonie maximale tolérable étant d'environ 10 %, l'épaisseur h de l'intervalle 469 ne doit pas dépasser 1,5 microns.

On conçoit donc l'intérêt de disposer d'un matériau électrooptique donc la constante diélectrique est aussi faible que possible et qui en même temps présente un coefficient électrooptique aussi élevé que possible.

Le rapport de l'indice de sensibilité électrooptique du cristal $n^3r$ (n étant l'indice de refraction du milieu et r son coefficient électrooptique) à la constante diélectrique e' constitue donc une information (figure de mérite) intéressante pour la sélection des matériaux propres à constituer la couche électrooptique 451.

Le tableau ci-après fournit une indication de ce rapport pour différents cristaux.

| Cristal | $rn^3/e'$ | Dimensions disponibles Cm2 | Origine |
|---|---|---|---|
| MNA | 50 | 1 | France |
| ZnTe | 10.8 | 1 | USA |
| AsGa | 3 | 100 | France |
| CuCl | 1.9 | 1 | France |
| $LiNbO_3$ | 1.6 | 10 | USA |
| $Bi_{12}SiO_{20}$ | 1.2 | 12 | Japan |
| $Bi_4Ge_3O_{12}$ | 0.5 | 100 | France |
| $KNbO_3$ | 0.5 | 2 | France |

Avec le dispositif à plaque de BGO visé plus haut, on a obtenu une bonne détection de bits de test de 1 volt d'amplitude à une fréquence de 5 MHz appliqués en des points de tests écartés de 2 mm et séparés par un conducteur à la masse. L'épaisseur de l'organe d'interface élastomère était de 2 mm, les surfaces des contacts sans oxyde et recouvertes d'une couche de vernis de 5 microns d'épaisseur.

L'observation du tableau précédent montre qu'un composé organique tel que le MNA (2 méthyl -4- nitroaniline) présente une figure de mérite élevée susceptible de rendre ce type de corps très intéressant pour les applications envisagées.

Or un tel corps peut être mis en oeuvre non seulement sous la forme de cristal, mais également sous une forme combinée à un matériau de support dans lequel des molécules d'un tel composé électro-optiquement actif sont incorporées. On peut ainsi par exemple utiliser comme matériau de support le poly (méthyl, méthacrylate) PMMA avec une densité de MNA de 15 % environ. Le MNA est donc alors utilisé comme un dopant dont les molécules sont retenues dans la matrice de PMMA, afin de rendre la composition électro-optique. D'autres dopants possibles possédant des propriétés électrooptiques sont par exemple les suivants :
DAN          [4- (N,N-dimethylamino)-3- acetamidomitrobenzene]

COANP   [2-cyclo-octylamino -5- nitropyridine]
PAN     [4-N-pyrrolydino -3- acetaminomitrobenzene]
MBANP   [2-(alpha-methylbenzylanino)-5-nitropyridine]

Ce type de composé polymère fait actuellement l'objet de nombreux développements par plusieurs entreprises, universités et centres de recherche dans ce domaine tels que Lockheed Missiles and Space Company, Inc., Hoechst Celanese Corporation et d'autres grandes entreprises dans le domaine chimique. (Voir par exemple les communications du Symposium intitulé NATO Advanced Workshop : "Polymer for non linear optics", Sophia Antipolis, June 19-24, 1988).

Les polymères obtenus peuvent être utilisés pour former des films, des fibres ou des couches minces ou épaisses sur substrat quelconque.

Une caractéristique particulièrement intéressante de ces polymères est la possibilité de les mettre en oeuvre sous forme de films capables d'être produits en grandes quantités et à des coûts raisonnables. Ces films peuvent être mis en oeuvre soit en épaisseur de quelques microns (par exemple 10 microns) sur des supports transparents par exemple en verre. Ils peuvent être également délivrés directement sous forme de films souples composés par la juxtaposition de plusieurs épaisseurs de films élémentaires, (par exemple 500 microns d'épaisseur).

Après séchage, les molécules de produits électro-optiquement actifs sont emprisonnées dans une matière de support à l'état amorphe, sans orientation particulière. Pour rendre le matériau électro-optique il est nécessaire de le chauffer à une température suffisante pour permettre aux molécules actives de recouvrer une certaine mobilité à l'intérieur de la matrice. La valeur de cette température de transition peut varier suivant le polymère mais peut typiquement se situer aux environs de 100 à 120 °C. Dans cet état elles peuvent subir une orientation par rapport au support sous l'effet d'un champ électrique. Des molécules tendent à s'orienter dans la direction du champ excitateur. Plus le champ excitateur est fort, plus la proportion de molécules actives orientées dans la direction du champ est élevé.

Lorsque la température est abaissée à nouveau pendant que les molécules sont orientées sous l'effet d'un champ, elles conservent leur orientation. Le matériau conserve ainsi une structure orientée qui peut être révélée par un comportement optiquement anisotrope (effet Pockels) en présence d'un champ électrique. Ainsi, lorsque le matériau est frappé par une lumière incidente polarisée linéairement en l'absence de champ électrique, la lumière transmise ou réfléchie par le matériau ne subit aucune modification de polarisation. Au contraire, en présence d'un champ électrique, la lumière transmise subit une polarisation elliptique reliée linéairement à l'intensité de champ appliqué.

Sur la figure 12a on a représenté la distribution des indices dans un film électro-optique 500 réalisé avec un polymère du type précédemment discuté, dont les molécules ont été orientées par l'application d'un champ électrique, dit orienteur, dans une direction normale à sa surface pendant que sa température était abaissée en dessous de la zone de transition au delà de laquelle les molécules de dopant électro-optique perdent leur mobilité. En 502 on a représenté un ellipsoïde décrivant la distribution des indices de réfraction du matériau lorsqu'on lui applique un champ électrique (dit détecteur ou révélateur) perpendiculaire à son plan. Cet ellipsoïde décrit les variations de l'indice de réfraction du matériau suivant les directions de l'espace. Il possède une symétrie de révolution par rapport à la normale 504 au plan du film 500 qui traduit le fait que le matériau est optiquement isotrope parallèlement au plan du film.

Si on éclaire le film 500 avec un faisceau polarisé 506 d'incidence normale au film, la lumière retransmise par le film (par transmission ou après réflexion sur la face opposée 508 du film) ne verra pas son état de polarisation modifié. Cela explique que si on utilise un tel film par exemple à la place de la plaque de BGO 451 de la figure 9 on ne puisse pas détecter les tensions au noeud du circuit balayé. En revanche, un faisceau incident 510 oblique par rapport au plan du film verra son état de polarisation modifié.

Il convient donc dans ce cas d'utiliser un faisceau de lumière polarisée d'incidence oblique par rapport à la couche électro-optique pour pouvoir révéler l'effet Pockels créé par les tensions dans le circuit testé.

Sur la figure 12b, on a représenté en 512 l'ellipsoïde des indices obtenu dans le même matériau sous l'action d'un champ électrique détecteur, ou révélateur, normal au plan du film lorsque les molécules du film 500 ont été orientées au préalable parallèlement au plan de ce film par le champ électrique orienteur. Dans ce cas l'ellipsoïde des indices 512 présente une symétrie de révolution par rapport à un axe 513 dans le plan du film 500. Un faisceau incident normal 506 voit alors son angle de polarisation modifié en fonction de la différence des indices $n_2$ et $n_3$ suivant les axes principaux de l'ellipse dans le plan du film. Dans ces conditions le montage de la figure 9 (c'est-à-dire avec incidence normale) avec un dispositif d'analyse polarimétrique tel que représenté à la figure 3 permet d'exploiter l'effet Pockels créé par le circuit à tester dans un film polymère incorporé à la sonde optique du testeur ou à la carte.

Un dispositif pour orienter les molécules de composé actif dans le plan du film polymère est illustré aux figures 17 et 18 de façon schématique. Une bande de film polymère 800 est admise dans un four tunnel 801 chauffé à une température T aux environs de 100°C (légèrement supérieure à la température de transition évoquée précédemment). La bande est guidée dans l'entrefer entre deux plaques métalliques face à face 802 et 804 qui sont maintenues à un potentiel électrique continu + V identique. A la sortie 805 du four tunnel, la plaque entre dans un second tunnel 810 délimité par deux plaques métalliques en regard 812 et 814 qui sont maintenues par exemple à un potentiel nul. Il en résulte que l'intervalle 815 entre la sortie tunnel de chauffagé 801 et le second tunnel 810 est soumis à un champ électrique sensiblement uniforme et parallèle au plan de la bande 800 qui défile dans cet intervalle 815. Les molécules électro-optiquement actives du film tendent à s'orienter parallèlement à cette direction sous l'effet de ce champ immédiatement à la sortie 805 du tunnel 801. Deux séries de buses 818 et 819 de part et d'autre du film 800 débouchent dans l'intervalle 815 où elles délivrent un courant 820 de gaz inerte (par exemple de l'argon ou un hexaflorure de soufre $SF_6$) refroidi à - 40° sur les deux faces du film 800. Le gaz est aspiré entre les plaques du second tunnel par un dispositif non représenté. La température du film 800 franchit la zone de transition dans l'intervalle 815. Les molécules actives conservent une orientation préférentielle dans le plan du film qui achève de se refroidir dans le second tunnel.

Les données précédentes concernant l'orientation de la structure du film et l'incidence de la lumière de test permettent d'utiliser le film polymètre électro-optique 500 en vue du test de signaux dans les circuits par la méthode polarimétrique.

Alternativement, et selon un autre aspect de l'invention, on peut adopter une méthode d'interférométrie Perot-Fabry au lieu de polarimétrie pour mettre en évidence l'effet Pockels sous l'action des tensions à tester.

Sur la figure 19, est représentée une portion carte de circuit 840, du type circuit assemblé, comprenant un support 841 en matériau isolant sur une face duquel sont disposés plusieurs composants électroniques ; ces derniers sont reliés entre eux par des liaisons conductrices telles que 848.

Une couche ou plaque de matériau electro-optique 842 est disposée à proximité de la carte support 841 du circuit en contact avec la surface supérieure du conducteur 848. Elle reçoit, sous incidence normale, un faisceau laser 843 émis par une source laser 844. La face du film 842 tournée du coté de la source laser est recouverte d'une couche 845 de matériau conducteur et semi-transparent qui constitue un miroir semi-transparent à coefficient de réflexion de valeur moyenne. L'autre face du film 842 (du côté de la carte de circuit à tester) est recouverte d'une couche 846 d'un matériau conducteur électriquement et à fort coefficient de réflexion, par exemple une couche d'aluminium plus épaisse que la couche 845 de façon à réfléchir une partie substantielle de la lumière qui lui parvient. Une couche 847 est prévue pour absorber la fraction de lumière transmise par la face réfléchissante 846. La couche 847 peut être formée de pastilles ou de carreaux isolés les uns des autres pour éviter de créer des courts circuits entre des pistes conductrices voisines de la carte à tester 840.

Entre les lumières réfléchies par les miroirs 845 et 847 parallèles s'établissent des interférences ; le faisceau lumineux issu du film (portant sur la figure une double flèche) est dévié par un miroir semi-transparent 851 et posé sur le trajet commun du faisceau émis 843 et du faisceau issu 849 vers des moyens d'analyse optique 850 aptes à mesurer l'intensité du signal lumineux 849. De façon connue, le phénomène d'interférences est fonction de la distance séparant les miroirs, c'est-à-dire l'épaisseur (e) du film, de la longueur d'onde (lambda) et de l'indice de réfraction (n) du matériau constituant le film. Or l'indice "n" varie avec le champ électrique auquel est soumis le film, lui-même fonction du potentiel V que l'on cherche à mesurer.

Donc, la mesure de l'intensité du signal lumineux au récepteur 850 permet d'obtenir une mesure du potentiel V d'un point donné du circuit 800. On note en particulier que si la couche de matériau électro-optique 842 est un film polymère du type discuté précédemment (et qui pourrait, le cas échéant, être intégré à la carte 840) la mesure de l'effet Pockels est réalisable sous incidence perpendiculaire par cette technique interférométrique, même lorsque les molécules électro-optiques du film ont été orientées à l'origine perpendiculairement à son plan.

Afin de pallier les conséquences d'éventuelles différences d'épaisseur du film ou couche électro-optique, la source lumineuse est apte à émettre un faisceau lumineux de longueur d'onde variable. Ceci permet de déplacer le point de fonctionnement du dispositif sur la courbe caractéristique (figure 20) de l'intensité en fonction de PHI= [2PI/lambda]n.e., d'un point A situé sur une première partie de la courbe où I=Imax quel que soit PHI (donc de sensibilité nulle) à un point B situé sur une seconde partie de la courbe où I (compris entre Imax et 0) varie fortement en fonction de PHI ; la sensibilité est fonction de cette variation de I sur cette seconde partie de la courbe autour du joint B ; de préférence, le point B correspond à environ Imax/2. Une fois le point B déterminé, les mesures sont alors effectuées avec la longueur d'onde correspondant au point B.

Sur la figure 13, une carte de circuit imprimé 600 comprend un substrat 602 d'un matériau classiquement composé d'époxy et de fibre de verre qui comporte sur chacune de ses faces 603 et 604 des métallisations ou pistes conductrices telles que 605 et 606, formant un réseau auquel sont connectés des composants montés sur la carte.

La face 604 de la carte est revêtue d'une couche d'un film polymère électro-optique 608 qui s'étend sensiblement sur toute sa surface au-dessus des pistes métalliques 606 qui y sont disposées. Le film 608 est incorporé à la carte après la réalisation des métallisations, mais avant l'implantation des composants, par exemple par collage. Du côté de la face 604 il est revêtu d'un damier de miroirs élémentaires réalisés par dépôt d'une couche d'aluminium réfléchissante 609. La dimension des pastilles ou carreaux du damier est telle qu'un même carreau ne puisse pas établir de court-circuit entre deux pistes métalliques 606 voisines. Sur sa face opposée, le film 608 est revêtu d'une autre couche d'aluminium 610 sous une épaisseur suffisamment faible pour être transparente à la lumière de test envoyé sur la carte dans la direction 612. La couche 610 constitue une électrode de référence pour les champs électriques engendrés dans l'épaisseur de film 608 par les tensions appliquées aux conducteurs 606.

Sur sa face 603, la carte 600 porte des composants tels que l'élément discret 614 ou le boîtier de circuit intégré 616. Les composants comportent des pattes de connexion 618 qui traversent le substrat de carte dans des trous 620 disposés au droit de pistes métalliques 606, sur l'autre face de la carte, auxquelles ils sont connectés par des points de soudure 622. On a également représenté un composant 624 monté à la surface 604 de la carte, ses deux faces extrêmes 625 et 626 étant reliés à deux pistes métalliques 606 respectives par deux gouttes de soudure 628. Avant l'assemblage des composants 614, 616 et 624, des ouvertures telles que 630 ont été ménagées dans le film polymère 608 autour des futurs points de soudure 622 et 628 pour éviter tout contact électrique entre les soudures métalliques et l'électrode de référence 610. Ces ouvertures peuvent être réalisées par un détourrage avant l'implantation des composants sur la carte ou être aménagées dans le film 608 avant sa jonction avec la face 604 de la carte. Alternativement, un film prédécoupé ou des éléments de film prédécoupés en fonction des zones de la carte comportant les conducteurs à tester peuvent être mis en place sur la carte avant implantation. Les zones de contact telles que 632 entre la face supérieure des métallisations 606 et le film 608 fournissent des points de test. Ceux-ci peuvent être interrogés par l'envoi d'un faisceau laser incident et l'analyse du faisceau réfléchi par le miroir métallique 609 correspondant. Cette analyse s'effectue avec une sonde de test analogue au dispositif de la figure 9 dans lequel la plaque de BGO 451 et la couche d'interface 462 ont été supprimées. En effet, la lumière sortant de la lentille plan convexe 450 vient directement frapper la carte 600 montée au voisinage de sa face plane.

Le faisceau renvoyé par chaque point de la carte 600 testé, modifié par l'effet de la tension régnant en ce point est détecté et analysé par un dispositif tel que 319 de la figure 3. L'étroitesse du contact entre le film 608 et le conducteur 606 testé assure une excellente conversion optique des signaux à tester et une bonne résolution spatiale. Dans certaines configurations de cartes (Fig. 13bis) où les zones conductrices 606A à examiner sont par construction disposées à proximité d'une zone à la masse 606B, un champ électrique parallèle au plan du film électro-optique s'établit (lignes de champ 640, 641 Figure 13bis). On peut alors tester directement l'existence de ce champ sans qu'une contre-électrode telle que 610 soit nécessaire. L'effet Pockels se manifeste alors sous l'effet d'un champ sensiblement parallèle au plan du film et non plus perpendiculaire.

Selon un autre mode de réalisation de l'invention, on prévoit d'utiliser un film polymère électro-optique directement dans une sonde optique de testeur. En effet, les bonnes qualités de ces matériaux, tant sur le plan de leur coefficient électro-optique élevé que de leur faible constante diélectrique, les rendent tout à fait adaptés à cette application. Ils peuvent être mis en oeuvre sous forme de couche par exemple collée sur la face plane de la lentille plan convexe 450 (fig. 9) à la place de la plaque de cristaux de BGO 451.

Selon une autre technique avantageuse, on prévoit d'utiliser pour chaque type de carte imprimée testé un transducteur électrooptique spécifique pour ce type de carte. On met ici à profit le fait que le coût du polymère du type indiqué n'est pas très élevé. Il est donc possible de réaliser lors de chaque nouveau type de carte à tester un transducteur destiné à être associé à la sonde optique pendant le test mais qui est adapté à ce modèle de carte.

Le transducteur 700 (figure 14 et 15) se présente sous la forme d'une plaque 702 de verre ou d'une matière plastique transparente présentant peu de photoélasticité et facilement usinable de façon à pouvoir y créer des ouvertures ou des cavités à l'intérieur desquelles viennent se loger les composants, les points de soudure et autres inégalités à la surface supérieure d'une carte de circuit imprimé 705 lorsqu'on vient y accoler le transducteur 700 pour le test.

Sur la face 710 du transducteur 700 est plaqué un film polymère électro-optique 712 du type déjà décrit par exemple en référence à la figure 12. Le film 712 est revêtu d'une électrode d'aluminium transparente 714 à son interface avec la plaque support 702. La face inférieure du film 712 est revêtue d'une couche réfléchissante 716, également en aluminium. Comme précédemment, cette couche n'est pas continue, mais formée de carreaux espacés les uns des autres, de façon telle qu'un carreau en contact avec un conducteur à la surface de la carte ne puisse pas également contacter, ou voir son potentiel influencé par un conducteur voisin.

Des ouvertures 720, 721, par exemple sont ménagées dans le transducteur 700 pour laisser passer des composants tels que 724 ou loger des gouttes de soudure telles que 725 à l'aide desquelles les pattes 726 de composants 727 traversant la carte 705 sont fixées à des conducteurs 728 à la surface 730 de la carte vis-à-vis de laquelle est placé le transducteur 700. La plaque 702 confère au transducteur 700 une rigidité suffisante pour permettre de plaquer le film polymère électro-optique 712 contre les conducteurs tels que 728 et 732 à la surface 730 de la carte 705 lorsque la carte 705 et le transducteur 700 sont rapprochés l'un de l'autre, par un dispositif de manipulation non représenté. Les capacités parasites entre le film sensible 712 et les contacts sont à un niveau minimum qui permet d'obtenir une bonne résolution spatiale, par exemple 0,1 mm, avec un vernis de 10 microns d'épaisseur. Ce résultat est sensiblement supérieur à la résolution possible avec un élastomère d'interface relativement épais tel que décrit en référence aux figures 1 à 3. La faible épaisseur de cette couche permet de maintenir la diaphonie entre des points de test très voisins des valeurs acceptables.

La plaque de support peut être usinée par des moyens mécaniques ordinaires. Le film sensible (figure 15) peut être lui-même usiné par laser. L'ensemble de transducteur 700 peut venir se fixer directement en contact avec (ou au voisinage immédiat de) la face plane de la lentille de champ (cf. 450 Fig.9) de la sonde optique à la place de l'ensemble formé par la plaque de BGO 451 et l'interface élastomère 462. Il peut au contraire être manipulé séparément de cette lentille lors de la mise en place de la carte à tester. Comme dans le cas d'une carte électro-optique de la figure 13, les portions de couches ou films électro-optiques sensibles peuvent être individualisées et limitées à un nombre prédéterminé de points ou de zones test répartis à la surface de la carte. Des zones sans miroirs ou des fenêtres 727 sont prévues dans le transducteur 700 pour permettre le repérage de repères 728 à partir desquels le système de déflexion de faisceau est recalibré pour diriger le faisceau incident avec précision vers les conducteurs ou noeuds à tester dans le circuit. Le dispositif de commande de l'ensemble de déflexion 433, 443, 444 (figure 9) peut être ainsi programmé pour venir interroger sélectivement des noeuds de la carte correspondant à des zones du transducteur qui ont été garnies de matériau ou film électro-optique.

La figure 16 représente schématiquement une vue en coupe d'un film électro-optique 740 pourvu d'une électrode de référence transparente 742 sur une de ses faces. Son autre face est garnie d'un damier de petits miroirs 744 réalisés par dépôt d'aluminium épais. Pour augmenter encore le contraste des mesures, le polymère est attaqué (chimiquement par exemple) entre les miroirs pour créer des gorges 706 sur une profondeur de l'ordre de la résolution demandée (0,1 mm par exemple). On réduit ainsi considérablement la capacité entre deux miroirs 744 voisins. Ce film peut être utilisé dans le transducteur 700 dans les figures 14 et 15.

Outre le fait, déjà signalé, que l'invention permet de tester des cartes finies, c'est-à-dire recouvertes de vernis, un autre avantage de l'invention est que l'activité des noeuds internes peut être observée avec une perturbation tout-à-fait négligeable par rapport à celle qui est nécessairement introduite dans les testeurs classiques. En effet, tout contact avec une sonde, c'est-à-dire avec un élément dans lequel s'établit une circulation de courant, perturbe le fonctionnement normal du circuit testé, de sorte que celui-ci peut, avec les testeurs de l'art antérieur, ne pas se comporter de la même façon lorsqu'il est examiné et lorsqu'il ne l'est pas.

Dans les testeurs conventionnels, la vitesse maximale à laquelle un circuit testé peut fonctionner peut, le cas échéant, être limitée pour les besoins du test. Ainsi, les tests ne sont pas conduits dans le même environnement opérationnel que celui dans lequel le circuit doit normalement fonctionner. Ceci constitue un problème majeur dans les testeurs fonctionnels dont la sonde de diagnostic manuelle a une capacité élevée (de l'ordre de 100 pF). En revanche, l'organe d'interface 18 peut n'avoir qu'une capacité de 1 pF, autorisant ainsi un fonctionnement du circuit à pleine vitesse pendant son test.

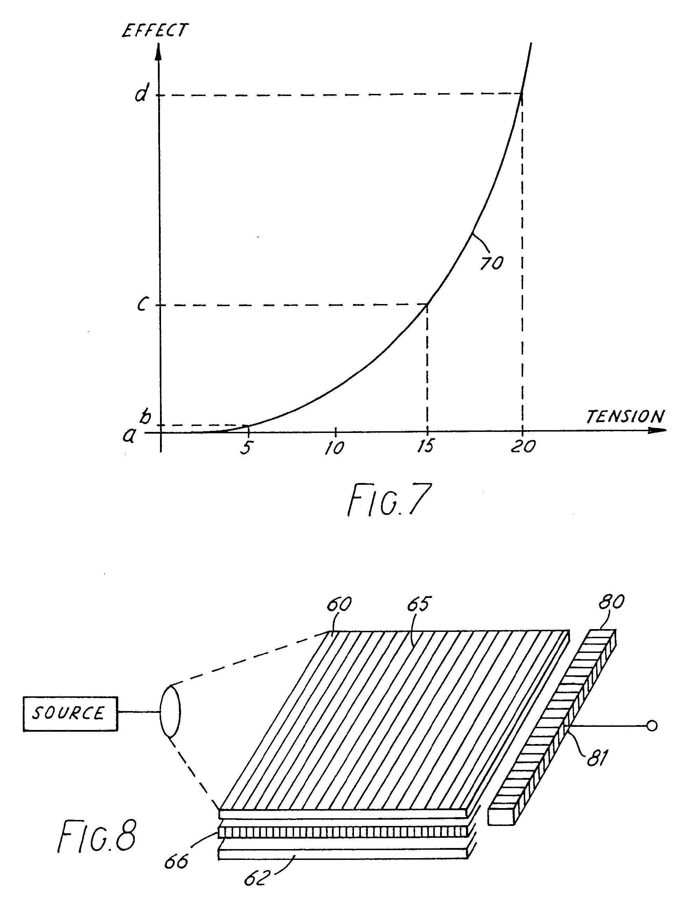

Les matériaux électro-optiques mentionnés précédemment produisent un effet électro-optique essentiellement linéaire aux longueurs d'onde envisagées (effet Pockels). C'est-à-dire que la variation de l'angle de polarisation d'un faisceau traversant ces matériaux sous l'effet d'un champ électrique dans l'espace traversé est proportionnelle à ce champ. D'autres matériaux présentent un effet quadratique (effet Kerr) selon lequel la variation d'angle de polarisation est proportionnelle au carré du champ électrique. Cette propriété est mise en application dans un autre mode de réalisation de l'invention (figure 6), où la lumière est dirigée de façon globale et latéralement sur un milieu électro-optique quadratique 60 disposé électriquement à proximité de conducteurs, tels que le conducteur 61, imprimés sur une carte 62 d'un circuit électrique à tester.

La lumière est recueillie au delà de la face latérale opposée du milieu 60 par un détecteur 63 qui produit un signal de sortie, disponible en 64, qui peut être utilisé par l'ATE comme précédemment décrit.

Des électrodes, telles que l'électrode 65, sont disposées sur la surface supérieure du milieu électro-optique 60 le long du trajet de la lumière. Des connexions électriques (non représentées) permettent de porter chaque électrode à un potentiel de polarisation choisi, par exemple à zéro volt ou à 20 volts par rapport au potentiel de référence.

Dans ces conditions, l'état de la lumière transmise et reçue par le détecteur 63 dépend des potentiels électriques apparaissant de part et d'autre du milieu électro-optique. Dans la mesure où le circuit disposé au dessous de ce milieu est excité, les potentiels électriques qui s'y développent sont retransmis vers la face inférieure du milieu 60 par l'intermédiaire de l'organe d'interface 66. Pour prendre l'exemple d'un circuit numérique, ayant un 0 logique à 0 volt et un 1 logique à 5 volts, et en supposant que toutes les électrodes de polarisation 65 sont portées au potentiel de 0 volt, la différence de potentiel appliquée de part et d'autre du milieu électro-optique 60 est soit de 0 volt, soit de 5 volts.

La caractéristique (figure 7) du milieu électro-optique choisi pour ce mode de réalisation de l'invention, par exemple un composé céramique PLZT du type utilisé pour la commande de portes optiques sur faisceaux laser, est une courbe 70, reliant l'effet électro-optique à la différence de potentiel.

Ainsi, pour un potentiel appliqué de 0 à 5 volts, l'effet électro-optique sera détecté entre les points a et b en ordonnées. Supposons maintenant qu'une électrode, par exemple 65, soit polarisée à un potentiel de 20 V. La différence de potentiel apparaissant de part et d'autre du milieu 60 dans la région du conducteur 61 est donc soit 20 volts (0 logique), soit 15 volts (1 logique). Ces différences de potentiel peuvent produire un effet dont l'intensité est représentée en ordonnées entre les points c et d. On comprend ainsi que les signaux dynamiques apparaissant dans la région d'une électrode polarisée à un potentiel non nul peuvent être discriminés des effets cumulatifs produits dans la région de l'électrode non polarisée, c'est-à-dire reliée à un potentiel nul, la variation de c à d étant beaucoup plus importante que celle de a à b. Ainsi, par une polarisation sélective des électrodes, l'activité électrique dans toute région le long du trajet de la lumière peut être examinée.

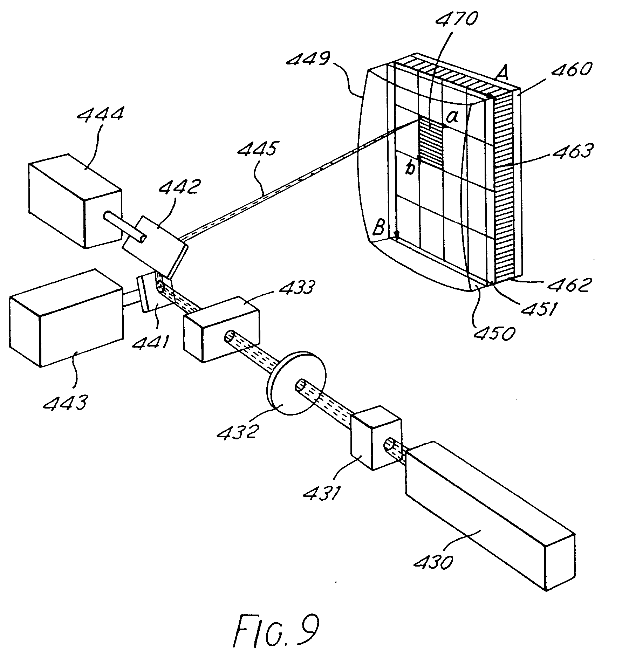

Pour examiner une région d'activité, une série de détecteurs 80 (figure 8) s'étendant le long du bord du milieu électro-optique qui est opposé à celui auprès duquel est disposé la source est nécessaire. Les éléments identiques apparaissant aux figures 6 et 8 sont affectés de la même référence.

Les électrodes de polarisation, telles que l'électrode 65, adoptent la forme de bandes qui s'étendent d'un bord à l'autre du milieu électro-optique 60, dans une direction sensiblement perpendiculaire à la direction moyenne de propagation de la lumière dans ce milieu, de sorte que l'activité électrique de toute région peut être examinée en polarisant l'électrode qui passe par cette région et en sélectionnant le signal de sortie du détecteur, tel que 81, qui reçoit la lumière qui a traversé cette région.

La façon dont le fonctionnement d'un ATE conforme à la présente invention peut être conçu sera maintenant décrit.

Dans un circuit assemblé tel qu'une carte de circuit imprimé, l'état de chacune des bornes de sortie dépend évidemment des états antérieurs des bornes d'entrée ; par exemple, l'état $S_k$ de la kième borne de sortie, pour un circuit dont le fonctionnement est correct, est une fonction $F_k$ de l'ensemble $[E]$ des états des bornes d'entrée, ce qui peut s'écrire : $S_k = F_k([E])$.

Le rôle assigné aux testeurs fonctionnels de l'art antérieur est de vérifier que pour un ensemble $[E]$ d'états assignés aux bornes d'entrée du circuit, l'état de chaque borne de sortie, tel que l'état $S_k$ de la kième, est bien déduit de l'ensemble $[E]$ des états des bornes d'entrée par l'application d'une fonction, telle que $F_k$, qui caractérise le fonctionnement d'un circuit correct.

Si tel n'est pas le cas, c'est-à-dire si l'état d'au moins une borne, telle que la kième, n'est pas correct, et par exemple $S'_k$ au lieu de $S_k$, le circuit testé est indubitablement défectueux.

Cette information n'est cependant d'aucune aide pour la remise en état du circuit, et l'on peut, pour mieux le comprendre remarquer que la dépendance de $S_k$ et de $[E]$ est très complexe.

Si, en effet, on veut l'expliciter davantage, on est conduit à considérer que l'état de chacune des bornes de sortie dépend de l'état des bornes d'entrée par l'intermédiaire des états qu'adoptent les noeuds internes du circuit. Pour un circuit correct, on peut donc écrire que l'état $S_k$ de la kième borne de sortie dépend, par une fonction qu'on notera $G_k$, de l'ensemble $[E]$ des états des bornes d'entrée non pas directement, mais par l'intermé diaire de l'état $I_1$ du premier noeud interne, de l'état $I_2$ du second noeud interne, etc..., ce qui peut s'écrire, dans le cas d'un circuit à n noeuds internes :

$$S_k = G_k (I_1, I_2,..., I_n).$$

Si, au lieu d'adopter l'état $S_k$, la kième borne de sortie adopte l'état $S'_k$, c'est peut-être parce qu'au lieu d'adopter l'état $I_1$, le premier noeud adopte un état $I'_1$, et/ou parce qu'au lieu d'adopter l'état $I_3$, le troisième noeud adopte un état $I'_3$, etc..., ce qui conduit à un ensemble de possibilités telles que :

$$S'_k = G_k (I'_1, I_2,..., I_n)$$

ou

$$S'_k = G_k (I_1, I_2, I'_3,..., I_n)$$

ou

$$S'_k = G_k (I'_1, I_2, I'_3,..., I_n),$$

etc...

En général, l'apparition d'un état anormal $S'_k$ peut être à priori dû à un grand nombre de causes possibles, parmi lesquelles un testeur fonctionnel classique ne peut discerner la cause réelle sans le recours à des procédures complémentaires longues et délicates.

En revanche, un ATE conforme à l'invention peut, pour le diagnostic, c'est-à-dire après la mise en évidence d'une défaillance fonctionnelle du circuit testé, se manifestant par au moins un résultat anormal à l'examen des noeuds de sortie de ce circuit, être utilisé de la façon suivante. Tout d'abord un noeud interne est choisi et examiné, et toutes les combinaisons possibles ou souhaitables d'états sont appliquées aux bornes d'entrée du circuit tandis que les états correspondants du noeud examiné sont enregistrés. Sur la base des résultats obtenus, le plus grand nombre d'hypothèses possibles de disfonctionnement sont éliminées.

Puis un autre noeud est choisi et la même procédure est répétée. Les noeuds internes sont ainsi tour à tour examinés jusqu'à la mise en évidence de l'origine du défaut.

L'homme de l'art comprendra néanmoins que la présente invention ne se limite pas au seul mode d'exploitation précédemment décrit et autorise, notamment, le recours aux techniques classiques de dépistage amont (connues sous le terme anglais de "backtracking"), y compris l'utilisation de systèmes experts.

L'homme de l'art comprendra également que bien que les modes de réalisation décrits ne fassent état que d'un seul faisceau lumineux, l'utilisation de plusieurs faisceaux appartient au domaine de la présente invention.

Enfin le montage qui vient d'être décrit pour le test de circuits peut être couplé avec un dispositif d'analyse en fréquence des signaux délivrés par un tel circuit. Dans le système décrit jusqu'à présent les signaux sont enregistrés en temps réel et le test tient uniquement compte de la présence ou absence d'impulsions aux instants prévus. La bande passante du système, limitée par celle des détecteurs utilisés, peut se trouver au voisinage de 100 MHz par exemple.

Une analyse fine de fronts d'onde à une fréquence très supérieure peut cependant être obtenue en opérant comme il est décrit ci-après en référence à la figure 21, selon une technique par échantillonnage (stroboscopie).

Un laser CW du type déjà discuté 901 est prévu pour envoyer la lumière de test vers un système optique 902. Ce système est du type décrit précédemment. Il produit et balaie un faisceau de lumière d'analyse 903 envoyé en direction du circuit à tester 907 à travers un dispositif électro-optique 910 comportant par exemple une lentille de champ et un transducteur électro-optique du type décrit en référence à la figure 9. Les signaux optiques réfléchis sont déviés par un séparateur et transmis à un détecteur 914.

Un deuxième laser 920 de type pulsé est prévu qui émet à un taux de répétition prédéterminé des impulsions de durée très brève par rapport à la durée des signaux produits aux noeuds du circuit en réponse aux excitations de test appliquées aux entrées 922 du circuit 907.

Les impulsions lumineuses du laser 920 sont envoyées d'une part sur un photodétecteur 924 et d'autre part, par un séparateur 925, à travers une ligne à retard optique réglable 926, vers un réflecteur 932 qui dirige les impulsions vers l'entrée du système optique 902 selon le même axe que la lumière issue du laser 900. La ligne à retard 926 comprend deux réflecteurs mobiles 927 et 928 permettant de couder à angle droit deux fois la direction du faisceau issu du séparateur 925, et un réflecteur fixe 929 pour réaligner le faisceau en direction du réflecteur 932. Le retard optique imposé au faisceau entre le laser pulsé 920 et le système optique 902 peut être modulé en rapprochant ou en éloignant conjointement les deux réflecteurs 927 et 928 du miroir fixe 929 (flèche 930).

La sortie électrique du photo détecteur 924 est reliée à un dispositif de synchronisation 940 qui commande le générateur de signaux de test 942 raccordés aux entrées 922 de la carte du circuit 907 de telle manière que les impulsions électriques soient appliquées sur ces entrées avec un taux de répétition égal à celui du laser pulsé.

La durée des impulsions du laser 920 est très courte devant celle des impulsions aux entrées 22. Le signal délivré par le système de détection 914, de bande passante faible devant la longueur des impulsions laser, est intégré sur un grand nombre d'échantillons. Chaque point d'un front d'onde ou un noeud du circuit peut être ausculté par un réglage convenable du retard sur le trajet optique entre le laser pulsé 920 et le système optique 902.

Alternativement, on peut créer un retard électrique réglable sur la transmission des impulsions de synchronisation. En fonctionnement de test le laser continu 900 émet ; le laser pulsé est au repos. Pour effectuer une analyse temporelle fine on arrête le laser 900 et on excite le laser pulsé 920.

## Revendications

1. Dispositif destiné à permettre le test d'un circuit, (11, 15, 16, 17) tel qu'une carte de circuit imprimé, circuit comprenant une pluralité de composants électroniques (15) disposés sur un support isolant (11) et reliés les uns aux autres par un réseau de conducteurs (16, 17) s'étendant sur une surface (12) au moins du support, **caractérisé en ce que** le dispositif comprenant une couche (10) d'un milieu électro-optique de dimensions sensiblement égales à celles du circuit, propre à être disposée à proximité de la surface porteuse de conducteurs, en vue de permettre d'analyser les modifications d'une lumière incidente sous l'effet des tensions apparaissant dans lesdits conducteurs en réponse à l'application de signaux de tests au circuit testé et en ce que le dispositif comprenant en outre des moyens (30 à 33) pour diriger de la lumière sur une région quelconque du milieu électro-optique, et pour recevoir de la lumière en provenance de cette région, de façon telle que les effets électro-optiques apparaissant dans le milieu puissent être détectés, et des moyens pour appliquer une configuration de signaux de test électriques sur un ou plusieurs noeuds externes (106) de manière qu'un signal de réponse soit produit sur au moins un noeud du circuit, la lumière étant susceptible d'être dirigée sur une région du milieu électro-optique qui est électriquement à proximité d'un conducteur constituant ce noeud, de manière à en produire une image et en ce que le dispositif comprenant des moyens (109) pour comparer ladite image avec la réponse que doit avoir le circuit correct et pour produire un signal de sortie représentant le résultat de la comparaison.

2. Dispositif selon la revendication 1 **caractérisé en ce que** dans le dispositif de la lumière peut être globalement dirigée sur le milieu électro-optique, ou sur une partie de ce dernier, ce milieu électro-optique comportant une pluralité de sites (65) individuellement susceptibles de subir une polarisation électrique, sur le trajet de la lumière, ces sites étant individuellement susceptibles d'être mis en fonctionnement par polarisation, de façon telle que la lumière détectée à la sortie soit représentative d'une région individuelle du milieu.

3. Dispositif suivant la revendication 2 **caractérisé en ce que** dans le dispositif la lumière est détectée par une série de détecteurs (80) dont chacun possède une sortie propre et en ce que la couche électro-optique a une structure telle qu'elle est sensible à la composante du champ électrique qui est perpendiculaire à son plan.

4. Dispositif suivant l'une quelconque des revendications 1 à 3, **caractérisé en ce que** le dispositif conçu pour opérer en tant que testeur fonctionnel, susceptible d'entrer dans une phase de test dans laquelle seules les entrées et sorties externes du circuit sont excitées et observées, et susceptible d'entrer, en cas de défaillance révélée par la phase de test, dans une phase de diagnostic dans laquelle un plus grand nombre de noeuds, y compris des noeuds internes, sont examinés.

5. Dispositif suivant l'une quelconque des revendications précédentes, **caractérisé en ce que** les noeuds sont examinés tour à tour, un ensemble de configurations de signaux de test étant appliqué à chaque examen et en ce que les configurations possibles de signaux de test susceptibles d'affecter un noeud en cours d'examen, sont appliquées de façon consécutive.

6. Dispositif selon l'une quelconque des revendications précédentes, **caractérisé en ce que** le dispositif est électriquement placé à proximité de la surface (12) porteuse de conducteurs par l'intermédiaire d'un organe d'interface (18) propre à reporter sur le milieu électro-optique les potentiels électriques se manifestant sur ladite surface.

7. Dispositif selon la revendication 6, **caractérisé en ce que** ledit organe d'interface (18) comprend une pluralité de colonnes conductrices (111) essentiellement parallèles les unes aux autres et isolées les unes des autres.

8. Dispositif selon l'une quelconque des revendications 6 et 7, **caractérisé en ce que** l'organe d'interface (18) a une surface profilée et/ou ajourée pour épouser le contour du circuit assemblé.

9. Dispositif selon la revendication 1, ou l'une quelconque des revendications précédentes **caractérisé en ce que** le milieu électro-optique est formé par un film polymère doté de propriétés électro-optiques et directement appliqué sur les conducteurs avant implantation des composants.

10. Dispositif selon l'une quelconque des revendications précédentes **caractérisé en ce que** les moyens pour diriger la lumière sur toute région du milieu électro-optique comprend deux déflecteurs électro-acoustiques montés en série.

11. Dispositif selon l'une quelconque des revendications précédentes **caractérisé en ce que** le milieu électro-optique comprend des cristaux d'épaisseurs sensiblement identiques et présentant des orientations perpendiculaires l'une à l'autre.

12. Dispositif selon l'une quelconque des revendications précédentes **caractérisé en ce que** la lumière comprend un ensemble de faisceaux individuellement orientables.

13. Dispositif selon l'une des revendications précédentes **caractérisé en ce que** la face de la couche électro-optique opposée à sa faxe à proximité électrique des conducteurs est pourvue d'une couche conductrice destinée à être raccordée à un potentiel de référence.

14. Dispositif selon l'une des revendications précédentes, **caractérisé en ce que** la face de la couche électro-optique à proximité électrique de la surface porteuse de conducteurs est pourvue d'au moins un revêtement réfléchissant la lumière incidente ayant traversé la couche électro-optique.

15. Dispositif selon l'une des revendications précédentes, **caractérisé en ce que** la couche électro-optique est constituée par un film polymère électro-optique.

16. Dispositif selon la revendication 15, **caractérisé en ce que** les molécules électro-optiques du film polymère sont orientées suivant une direction préférentielle perpendiculaire au plan du film.

17. Dispositif selon la revendication 15, **caractérisé en ce que** les molécules électro-optiques du film polymère sont orientées suivant une direction préférentielle parallèle au plan du film.

18. Dispositif selon l'une des revendications 15 à 17, **caractérisé en ce que** le film polymère est associé en permanence à la surface du support du circuit.

19. Dispositif selon l'une des revendications 15 à 18, **caractérisé en ce que** le film polymère est adapté à la configuration du circuit à tester et propre à être amené à la surface du support de celui-ci après l'implantation de ses composants électroniques.

20. Dispositif selon la revendication 19, **caractérisé en ce que** le film polymère est adapté à être placé au contact du circuit au moment de son montage en vue du test dans une sonde optique comportant des moyens pour transmettre de la lumière vers une zone prédéterminée du film polymère et pour recevoir en réponse de la lumière de cette zone de façon telle que les effets électro-optiques apparaissant dans ce film puissent être détectés.


**Patentansprüche**

1. Vorrichtung zum Ermöglichen des Testens einer Schaltung (11, 15, 16, 17), wie einer gedruckten Schaltungskarte, welche Schaltung eine Mehrzahl von elektronischen Komponenten (15) umfaßt, die auf einem isolierenden Träger (11) angeordnet sind und miteinander über ein Netz von Leitern (16, 17) verbunden sind, das sich auf mindestens einer Oberfläche (12) des Trägers erstreckt, dadurch gekennzeichnet, daß die Vorrichtung eine Schicht (10) aus einem elektrooptischen Milieu mit Abmessungen im wesentlichen gleich jenen der Schaltung umfaßt, die nahe der die Leiter tragenden Oberfläche angeordnet werden kann, um das Analysieren von Modifikationen eines auftreffenden Lichtes unter der Wirkung von Spannungen zu ermöglichen, die in den Leitern in Reaktion auf das Anlegen von Testsignalen an die zu testende Schaltung erscheinen, daß die Vorrichtung ferner Mittel (30 bis 33) umfaßt zum Richten des Lichtes auf irgendeinen Bereich des elektrooptischen Milieus und zum Empfang von Licht, das von diesem Bereich herrührt derart, daß die elektrooptischen Effekte, die in dem Milieu erscheinen, erfaßt werden können, und Mittel zum Anlegen einer Konfiguration von elektrischen Testsignalen an einen oder mehrere externe Knoten (106) derart, daß ein Reaktionssignal auf mindestens einem Knoten der Schaltung erzeugt wird, wobei das Licht auf einen Bereich des elektrooptischen Milieus richtbar ist, der elektrisch nahe einem diesen Knoten bildenden Leiter angeordnet ist derart, daß dort ein Bild erzeugt wird, und daß die Vorrichtung Mittel (109) umfaßt zum Vergleichen dieses Bildes mit der Reaktion, die eine einwandfreie Schaltung haben sollte und zum Erzeugen eines Ausgangssignals, das das Ergebnis dieses Vergleichs repräsentiert.

2. Vorrichtung nach Anspruch 1, dadurch gekennzeichnet, daß in der Vorrichtung Licht global auf das elektrooptische Milieu gerichtet werden kann oder auf eine Partie dieses letzteren, wobei dieses elektrooptische Milieu eine Mehrzahl von Orten (65) umfaßt, die individuell einer elektrischen Polarisation unterwerfbar sind auf der Bahn des Lichtes, wobei diese Orte individuell durch Polarisation in Funktion setzbar sind derart, daß das am Ausgang erfaßte Licht repräsentativ ist für eine individuelle Region des Milieus.

3. Vorrichtung nach Anspruch 2, dadurch gekennzeichnet, daß in der Vorrichtung das Licht erfaßt wird durch eine Serie von Detektoren (80), von denen jeder einen eigenen Ausgang aufweist, und daß die elektrooptische Schicht eine Struktur derart aufweist, daß sie empfindlich ist gegenüber der Komponente des elektrischen Feldes, die senkrecht zu seiner Ebene ist.

4. Vorrichtung nach einem der Ansprüche 1 bis 3, dadurch gekennzeichnet, daß die Vorrichtung für die Betriebsweise als Funktionstester konzipiert ist und in eine Testphase bringbar ist, in der nur die externen Eingänge beziehungsweise Ausgänge der Schaltung erregt beziehungsweise beobachtet werden, und im Falle des beobachteten Versagens in der Testphase in eine Diagnosephase bringbar ist, in der eine größere Anzahl von Knoten einschließlich interner Knoten überprüft wird.

5. Vorrichtung nach einem der vorangehenden Ansprüche, dadurch gekennzeichnet, daß die Knoten Zug um Zug untersucht werden, wobei eine Gruppe von Signalkonfigurationen des Tests bei jeder Überprüfung angelegt werden, und daß die möglichen Testsignalkonfigurationen, mittels denen ein Knoten während der Überprüfung beeinflußbar ist, nacheinander angelegt werden.

6. Vorrichtung nach einem der vorangehenden Ansprüche, dadurch gekennzeichnet, daß die Vorrichtung elektrisch nahe der die Leiter tragenden Oberfläche (12) plaziert wird über ein Schnittstellenorgan (18), geeignet zum Übertragen der elektrischen Potentiale, die sich auf der Oberfläche manifestieren auf das elektrooptische Milieu.

7. Vorrichtung nach Anspruch 6, dadurch gekennzeichnet, daß das Schnittstellenorgan (18) eine Mehrzahl von leitenden Kolonnen (111) umfaßt, die im wesentlichen parallel zueinander verlaufen und voneinander isoliert sind.

8. Vorrichtung nach einem der Ansprüche 6 und 7, dadurch gekennzeichnet, daß das Schnittstellenorgan (18) eine profilierte und/oder ausgeschnittene Oberfläche aufweist zur Anpassung an die Kontur der fertiggestellten Schaltung.

9. Vorrichtung nach Anspruch 1 oder einem der vorangehenden Ansprüche, dadurch gekennzeichnet, daß das elektrooptische Milieu von einem Polymerfilm gebildet wird, der mit elektrooptischen Eigenschaften dotiert ist und direkt auf die Leiter vor der Einfügung der Komponenten aufgebracht wird.

10. Vorrichtung nach einem der vorangehenden Ansprüche, dadurch gekennzeichnet, daß die Mittel zum Richten des Lichtes auf jeden Bereich des elektrooptischen Milieus zwei elektroakustische Ablenker umfaßt, die in Serie geschaltet sind.

11. Vorrichtung nach einem der vorangehenden Ansprüche, dadurch gekennzeichnet, daß das elektrooptische Milieu Kristalle im wesentlichen gleicher Dicke und mit Orientierungen senkrecht zueinander umfaßt.

12. Vorrichtung nach einem der vorangehenden Ansprüche, dadurch gekennzeichnet, daß das Licht eine Gruppe von einzeln orientierbaren Strahlen umfaßt.

13. Vorrichtung nach einem der vorangehenden Ansprüche, dadurch gekennzeichnet, daß die Seite der elektrooptischen Schicht, abgekehrt ihrer Seite, die elektrisch den Leitern nahe ist, mit einer leitenden Schicht versehen ist, dazu bestimmt, an ein Referenzpotential angeschlossen zu werden.

14. Vorrichtung nach einem der vorangehenden Ansprüche, dadurch gekennzeichnet, daß die Seite der elektrooptischen Schicht, elektrisch nahe der die Leiter tragenden Oberfläche, mit mindestens einer Beschichtung versehen ist, die das auftreffende, die elektrooptische Schicht durchsetzende Licht reflektiert.

15. Vorrichtung nach einem der vorangehenden Ansprüche, dadurch gekennzeichnet, daß die elektrooptische Schicht von einem elektrooptischen Polymerfilm gebildet ist.

16. Vorrichtung nach Anspruch 15, dadurch gekennzeichnet, daß die elektrooptischen Moleküle des Polymerfilms gemäß einer Vorzugsrichtung senkrecht zur Ebene des Films orientiert sind.

17. Vorrichtung nach Anspruch 15, dadurch gekennzeichnet, daß die elektrooptischen Moleküle des Polymerfilms gemäß einer Vorzugsrichtung parallel zur Ebene des Films orientiert sind.

**18.** Vorrichtung nach einem der Ansprüche 15 bis 17, dadurch gekennzeichnet, daß der Polymerfilm permanent der Oberfläche des Schaltungsträgers zugeordnet ist.

**19.** Vorrichtung nach einem der Ansprüche 15 bis 18, dadurch gekennzeichnet, daß der Polymerfilm an die Konfiguration der zu testenden Schaltung angepaßt ist und auf die Oberfläche von dessen Träger aufbringbar ist nach Einfügen ihrer elektronischen Komponenten.

**20.** Vorrichtung nach Anspruch 19, dadurch gekennzeichnet, daß der Polymerfilm angepaßt ist, in Kontakt mit der Schaltung plaziert zu werden im Augenblick ihrer Montage für den Test in einer optischen Sonde, umfassend Mittel für das Übertragen des Lichtes auf eine vorbestimmte Zone des Polymerfilms und für den Empfang in Reaktion auf das Licht dieser Zone derart, daß die in dem Film auftretenden elektrooptischen Effekte detektierbar sind.

## Claims

**1.** Device for testing a circuit (11, 15, 16, 17) such as a printed circuit board including a plurality of electronic components (15) disposed on an insulative support (11) and interconnected by an array of conductors (16, 17) on at least one surface (12) of the support, characterized in that the device includes a layer (10) of an electro-optical medium having substantially the same dimensions as the circuit and adapted to be disposed near the surface carrying the conductors to enable analysis of the modification of incident light due to the effect of voltages occurring on said conductors in response to application of test signals to the circuit under test, and in that the device further includes means (30 to 33) for directing light onto any region of the electro-optical medium and for receiving light from that region so that the electro-optical effects occurring in the medium can be detected and means for applying a configuration of test electrical signals to one or more external nodes (106) so that a response signal is produced at one node at least of the circuit, the light being directable onto a region of the electro-optical medium electrically near a conductor constituting said node to produce an image thereof, and in that the device includes means (109) for comparing said image with the response expected of a correct circuit and for producing an output signal representing the result of the comparison.

**2.** Device according to claim 1 characterized in that light can be directed onto the electro-optical medium globally or onto part of the medium, the electro-optical medium having a plurality of sites (65) on the path of the light which can be electrically biased individually and activated individually by biasing them so that light detected at the output is representative of an individual region of the medium.

**3.** Device according to claim 2 characterized in that the light is detected by a series of detectors (80) each having a respective output and in that the electro-optical layer has a structure such that it is sensitive to the component of the electric field perpendicular to its plane.

**4.** Device according to any one of claims 1 to 3 characterized in that the device is designed to operate as a functional tester adapted for use in a test phase in which only the external inputs and outputs of the circuit are excited and observed and to be used in a diagnostic phase if the test phase indicates a malfunction, in which diagnostic phase a greater number of nodes, including internal nodes, are examined.

**5.** Device according to any one of the preceding claims characterized in that the nodes are examined in turn, a set of configurations of test signals being applied for each examination, and in that the possible configurations of test signals likely to influence a node during examination are applied consecutively.

**6.** Device according to any one of the preceding claims characterized in that the device is disposed electrically near the surface (12) carrying the conductors via an interface unit (18) adapted to transfer to the electro-optical medium electrical potentials on said surface.

**7.** Device according to claim 6 characterized in that said interface unit (18) includes a plurality of mutually insulated substantially parallel conductive columns (111).

**8.** Device according to claim 6 or claim 7 characterized in that the interface unit (18) has a surface profiled or apertured to mate with the contour of the circuit assembly.

9. Device according to any one of the preceding claims characterized in that the electro-optical medium is formed by a polymer film having electro-optical properties and applied directly to the conductors before mounting the components.

10. Device according to any one of the preceding claims characterized in that the means for directing light onto any region of the electro-optical medium include two acoustic-optical deflectors in series.

11. Device according to any one of the preceding claims characterized in that the electro-optical medium includes crystals of substantially the same thickness in mutually perpendicular orientations.

12. Device according to any one of the preceding claims characterized in that the light includes a set of beams that can be oriented individually.

13. Device according to any one of the preceding claims characterized in that the side of the electro-optical layer opposite the side electrically near the surface carrying the conductors has at least one coating which reflects incident light transmitted by the electro-optical layer.

14. Device according to any one of the preceding claims characterized in that the side of the electro-optical layer electrically near the surface carrying the conductors has at least one coating which reflects incident light transmitted by the electro-optical layer.

15. Device according to any one of the preceding claims characterized in that the electro-optical layer is an electro-optical polymer film.

16. Device according to claim 15 characterized in that the electro-optical molecules of the polymer film are oriented in a preferred direction perpendicular to the plane of the film.

17. Device according to claim 15 characterized in that the electro-optical molecules of the polymer film are oriented in a preferred direction parallel to the plane of the film.

18. Device according to any one of claims 15 to 17 characterized in that the polymer film is permanently associated with the surface of the support of the circuit.

19. Device according to any one of claims 15 to 18 characterized in that the polymer film is matched to the configuration of the circuit under test and adapted to be applied to the surface of the support thereof after mounting of its electronic components.

20. Device according to claim 19 characterized in that the polymer film is adapted to be placed in contact with the circuit when it is mounted for testing in an optical probe including means for transmitting light towards a predetermined region of the polymer film and for receiving light returned from this region so that the electro-optical effects occurring in the film can be detected.

FIG.1

FIG.2

FIG.3

FIG.4

FIG.5

FIG.6

FIG.7

FIG.8

FIG. 9

FIG.10

FIG.11

28

FIG.12a

FIG.12b

FIG.13

FIG.13b

FIG.14

FIG.15

FIG.16

FIG.17

FIG.18

FIG.19

FIG.20

FIG.21